# EUROPEAN PATENT APPLICATION

(11) **EP 4 394 847 A1**
(43) Date of publication of application: **03.07.2024**
(21) Application number: 22861097.8
(22) Date of filing: 03.08.2022
(51) Int. Cl.: H01L 21/02, B05C 5/00, B05C 9/14, B05C 11/10, B05D 1/26, B05D 1/28, B05D 3/00, B05D 7/00, B05D 7/24, G06N 20/00, H01L 21/00, H01L 21/304, H01L 21/66, H01L 27/12

(54) **SUBSTRATE PROCESSING METHOD AND SUBSTRATE PROCESSING DEVICE**

(30) Priority: 26.08.2021 JP 2021137887; 31.08.2021 JP 2021140782; 13.07.2022 JP 2022112339
(71) Applicant: EBARA CORPORATION, Ota-ku, Tokyo 144-8510 (JP)
(72) Inventor: SATAKE, Masayuki, Tokyo 144-8510 (JP); NAKANISHI, Masayuki, Tokyo 144-8510 (JP); MITSUKI, Yuta, Tokyo 144-8510 (JP)
(74) Representative: Wimmer, Hubert
(86) International application number: PCT/JP2022/029792
(87) International publication number: WO 2023/026806

(57) **Abstract**

The present invention relates to a substrate processing method and a substrate processing apparatus for suppressing cracking and chipping of a laminated substrate manufactured by bonding substrates, and more particularly to a technique of applying a filler to a gap formed between edge portions of the substrates constituting the laminated substrate. The method includes: measuring surface shapes of an edge portion (E1) of a first substrate (W1) and an edge portion (E2) of a second substrate (W2); determining an applying condition for the filler (F) to be applied to the laminated substrate (Ws) based on results of the measuring of the surface shapes; and applying the filler (F) to a gap (G) between the edge portion (E1) of the first substrate (W1) and the edge portion (E2) of the second substrate (W2) of the laminated substrate (Ws) under the determined applying condition.

## Description

### Technical Field

The present invention relates to a substrate processing method and a substrate processing apparatus for suppressing cracking and chipping of a laminated substrate manufactured by bonding substrates, and more particularly to a technique of applying a filler to a gap formed between edge portions of the substrates constituting the laminated substrate.

### Background Art

In recent years, in order to achieve higher density and higher functionality in semiconductor devices, three-dimensional packaging technology, in which substrates are laminated and integrated three-dimensionally, has been developed. For example, in the three-dimensional packaging technology, a device surface of a first substrate on which integrated circuits and electrical wires are formed is bonded to a device surface of a second substrate on which integrated circuits and electrical wires are formed. After the first substrate is bonded to the second substrate, the second substrate is thinned by a polishing apparatus or a grinding apparatus. In this manner, integrated circuits can be stacked in a direction perpendicular to the device surfaces of the first substrate and the second substrate.

In the three-dimensional packaging technology, three or more substrates may be bonded to each other. For example, a third substrate may be bonded to the second substrate after the second substrate bonded to the first substrate has been thinned, and then the third substrate may be thinned. In this specification, a substrate in a form of substrates bonded to each other may be referred to as a "laminated substrate".

Generally, an edge portion of a substrate is polished in advance in a rounded shape or a beveled shape in order to prevent cracking or chipping of the edge portion. When the second substrate having such a shape is grinded, an acute edge is formed in the second substrate as a result of grinding. This acute edge (hereinafter referred to as a knife-edge portion) is constituted by a grinded back surface and a circumferential surface of the second substrate. Such a knife-edge portion is likely to be chipped by a physical contact, and the laminated substrate itself may be broken during transportation of the laminated substrate. Furthermore, insufficient bonding between the first substrate and the second substrate may cause the second substrate to be cracked during grinding.

Thus, a filler is applied to the edge portion of the laminated substrate before the second substrate is grinded in order to prevent the knife-edge portion from cracking or chipping. The filler is applied to a gap between an edge portion of the first substrate and an edge portion of the second substrate. The filler can support the knife-edge portion that has been formed after the second substrate is grinded, and can prevent cracking or chipping of the knife-edge portion.

### Citation List

### Patent Literature

Patent document 1: Japanese laid-open patent publication No. 05-304062

### Summary of Invention

### Technical Problem

However, when the filler is applied to the gap between the edge portion of the first substrate and the edge portion of the second substrate, a filling failure, such as lacking of the filler or over-applying of the filler, may occur. If the laminated substrate is processed in a subsequent process with the filling failure, the laminated substrate may be damaged, and as a result, the laminated substrate or a process performance may be adversely affected. Conventionally, filling of the filler that has been applied to the laminated substrate is checked after the application of the filler has been completed, and there were some cases that the laminated substrate should be destroyed.

Furthermore, insufficient applying amount of the filler may cause a void in the filler applied to the gap of the laminated substrate. Such a void is likely to cause cracking or chipping of the knife-edge portion when the second substrate is grinded. On the other hand, excessive applying amount of the filler may cause the filler to be removed from the laminated substrate, and the removed filler may contaminate surrounding environment.

There is the following problem in the thinning process for the laminated substrate, which is performed after the filler is applied. The thinning process for the laminated substrate is performed by grinding the second substrate with a grinding tool. However, depending on a hardness or a type of the applied filler, the grinding tool may be damaged, or particles (aggregate) contained in the filler may stick to the grinding tool to cause clogging of the grinding tool.

It is therefore an object of the present invention to provide a substrate processing method and a substrate processing apparatus capable of applying a filler to a gap between an edge portion of a first substrate and an edge portion of a second substrate under an appropriate applying condition.

Further, the present invention provides a substrate processing method and a substrate processing apparatus capable of applying a filler to a laminated substrate with an appropriate amount. Furthermore, the present invention provides a substrate processing method and a substrate processing apparatus capable of preventing clogging of a grinding tool and capable of improving throughput by optimizing a thinning condition for the laminated substrate.

### Solution to Problem

In an embodiment, there is provided a substrate processing method of applying a filler to a laminated substrate having a first substrate and a second substrate bonded to each other, comprising: measuring surface shapes of an edge portion of the first substrate and an edge portion of the second substrate; determining an applying condition for the filler to be applied to the laminated substrate based on results of measuring of the surface shapes; and applying the filler to a gap between the edge portion of the first substrate and the edge portion of the second substrate of the laminated substrate under the determined applying condition.

In an embodiment, measuring of the surface shapes of the edge portion of the first substrate and the edge portion of the second substrate is performed after the first substrate and the second substrate have been bonded.

In an embodiment, measuring of the surface shapes of the edge portion of the first substrate and the edge portion of the second substrate is performed before the first substrate and the second substrate are bonded.

In an embodiment, the surface shapes of the edge portion of the first substrate and the edge portion of the second substrate to be measured are specified by at least one of: (i) a dimension of the edge portion of the first substrate in a radial direction of the first substrate and a dimension of the edge portion of the second substrate in a radial direction of the second substrate; (ii) a dimension of the gap in a thickness direction of the gap between the edge portion of the first substrate and the edge portion of the second substrate; and (iii) an inclination angle of the edge portion of the first substrate and an inclination angle of the edge portion of the second substrate.

In an embodiment, the applying condition includes at least one of a composition of the filler, a total amount of the filler to be applied, a shape of a filler emitting port of an application device configured to apply the filler, a distance between the laminated substrate and the filler emitting port, and an amount of the filler to be emitted from the filler emitting port per unit time.

In an embodiment, the substrate processing method further comprises curing the filler after applying the filler to the laminated substrate, wherein the applying condition further includes wind pressure and temperature of hot air to be emitted from a curing device configured to cure the filler.

In an embodiment, applying of the filler is performed while rotating the laminated substrate, and the applying condition further includes a rotation speed of the laminated substrate.

In an embodiment, there is provided a substrate processing apparatus for applying a filler to a laminated substrate having a first substrate and a second substrate bonded to each other, comprising: a filler application module configured to apply the filler to the laminated substrate; a surface-shape measuring device configured to measure surface shapes of an edge portion of the first substrate and an edge portion of the second substrate; and an operation controller configured to control operations of the filler application module and the surface-shape measuring device, wherein the filler application module includes: a substrate holder configured to hold the laminated substrate; and an application device configured to apply the filler to a gap between the edge portion of the first substrate and the edge portion of the second substrate, and the operation controller is configured to determine an applying condition for the filler to be applied to the laminated substrate based on measuring results of the shapes, and instruct the filler application module to apply the filler under the determined applying condition.

In an embodiment, the surface-shape measuring device is configured to measure at least one of: (i) a dimension of the edge portion of the first substrate in a radial direction of the first substrate and a dimension of the edge portion of the second substrate in a radial direction of the second substrate; (ii) a dimension of the gap in a thickness direction of the gap between the edge portion of the first substrate and the edge portion of the second substrate; and (iii) an inclination angle of the edge portion of the first substrate and an inclination angle of the edge portion of the second substrate.

In an embodiment, the filler application module further includes a curing device configured to cure the filler.

In an embodiment, the filler application module further includes a rotating mechanism configured to rotate the substrate holder.

In an embodiment, there is provided a substrate processing method comprising: inputting data on a laminated substrate having a first substrate and a second substrate bonded to each other, and data on a filler into a trained model constructed by machine learning; outputting an applying condition for the filler from the trained model; and applying the filler to a gap between an edge portion of the first substrate and an edge portion of the second substrate according to the applying condition, while rotating the laminated substrate.

In an embodiment, the data on the laminated substrate include materials constituting surfaces of the first substrate and the second substrate, and a shape and a size of the gap, and the data on the filler include a composition of the filler.

In an embodiment, the applying condition includes at least one of a total amount of the filler to be applied, an amount of the filler to be applied per unit time, temperature of the filler, and a rotation speed of the laminated substrate.

In an embodiment, data on a curing device configured to cure the filler are input into the trained model in addition to the data on the laminated substrate and the data on the filler, the applying condition for the filler and a curing condition for the filler are output from the trained model, and the substrate processing method further comprises curing the applied filler by the curing device according to the curing condition.

In an embodiment, the data on the curing device include a type of the curing device, and a distance between the curing device and an edge portion of the laminated substrate.

In an embodiment, the curing condition includes an output value of the curing device.

In an embodiment, data on a thinning device configured to thin the laminated substrate are input into the trained model in addition to the data on the laminated substrate, the data on the filler, and the data on the curing device, the applying condition for the filler, the curing condition for the filler, and a thinning condition for the laminated substrate are output from the trained model, and the substrate processing method further comprises thinning the laminated substrate by the thinning device according to the thinning condition after curing of the filler.

In an embodiment, the data on the thinning device include a type of a grinding tool for use in the thinning device and a target amount of grinding of the laminated substrate.

In an embodiment, the thinning condition includes at least one of a pressing force of the grinding tool against the laminated substrate, a rotation speed of the grinding tool, and a rotation speed of the laminated substrate.

In an embodiment, the trained model is constructed by the machine learning using training data that include data on laminated substrates, data on fillers, and applying conditions as ground-truth labels.

In an embodiment, the trained model is constructed by the machine learning using training data that include data on laminated substrates, data on fillers, and data on curing devices and further include applying conditions and curing conditions as ground-truth labels.

In an embodiment, the trained model is constructed by the machine learning using training data that include data on laminated substrates, data on fillers, data on curing devices, and data on thinning devices and further include applying conditions, curing conditions, and thinning conditions as ground-truth labels.

In an embodiment, the substrate processing method further comprises: updating training data for use in the machine learning by adding, to the training data, the data on the laminated substrate and the data on the filler which have been input to the trained model, and the applying condition which has been output from the trained model; and performing machine learning using the updated training data to update the trained model.

In an embodiment, applying the filler to the gap between the edge portion of the first substrate and the edge portion of the second substrate according to the applying condition, while rotating the laminated substrate comprises applying the filler to the gap between the edge portion of the first substrate and the edge portion of the second substrate according to the applying condition, while rotating the laminated substrate held in a vertical posture.

In an embodiment, there is provided a substrate processing method comprising: inputting, into a trained model, data on a laminated substrate having a first substrate and a second substrate bonded to each other, data on a filler applied to a gap between an edge portion of the first substrate and an edge portion of the second substrate, and data on a thinning device configured to thin the laminated substrate, the trained model being constructed by machine learning; outputting a thinning condition for the laminated substrate from the trained model; and thinning the laminated substrate by the thinning device according to the thinning condition.

In an embodiment, there is provided a substrate processing apparatus comprising: an arithmetic system having a trained model constructed by machine learning; and a filler application module configured to apply a filler to a laminated substrate having a first substrate and a second substrate bonded to each other, while rotating the laminated substrate, wherein the arithmetic system is configured to: input data on the laminated substrate and data on the filler into the trained model; output an applying condition for the filler from the trained model; and instruct the filler application module to apply the filler to a gap between an edge portion of the first substrate and an edge portion of the second substrate according to the applying condition.

In an embodiment, the data on the laminated substrate include materials constituting surfaces of the first substrate and the second substrate, and a shape and a size of the gap, and the data on the filler include a composition of the filler.

In an embodiment, the applying condition includes at least one of a total amount of the filler to be applied, an amount of the filler to be applied per unit time, temperature of the filler, and a rotation speed of the laminated substrate.

In an embodiment, the substrate processing apparatus further comprises a curing device configured to cure the applied filler, the arithmetic system being configured to: input data on the curing device into the trained model in addition to the data on the laminated substrate and the data on the filler; output the applying condition for the filler and a curing condition for the filler from the trained model; and instruct the curing device to cure the applied filler according to the curing condition.

In an embodiment, the data on the curing device include a type of the curing device, and a distance between the curing device and an edge portion of the laminated substrate.

In an embodiment, the curing condition includes an output value of the curing device.

In an embodiment, the substrate processing apparatus further comprises a thinning device configured to thin the laminated substrate, the arithmetic system being configured to: input data on the thinning device into the trained model in addition to the data on the laminated substrate, the data on the filler, and the data on the curing device; output the applying condition for the filler, the curing condition for the filler, and a thinning condition for the laminated substrate from the trained model; and instruct the thinning device to thin the laminated substrate according to the thinning condition after curing of the filler.

In an embodiment, the data on the thinning device include a type of a grinding tool for use in the thinning device and a target amount of grinding of the laminated substrate.

In an embodiment, the thinning condition includes at least one of a pressing force of the grinding tool against the laminated substrate, a rotation speed of the grinding tool, and a rotation speed of the laminated substrate.

In an embodiment, the trained model is constructed by the machine learning using training data that include data on laminated substrates, data on fillers, and applying conditions as ground-truth labels.

In an embodiment, the trained model is constructed by the machine learning using training data that include data on laminated substrates, data on fillers, and data on curing devices and further include applying conditions and curing conditions as ground-truth labels.

In an embodiment, the trained model is constructed by the machine learning using training data that include data on laminated substrates, data on fillers, data on curing devices, and data on thinning devices and further include applying conditions, curing conditions, and thinning conditions as ground-truth labels.

In an embodiment, the arithmetic system is configured to: update training data for use in the machine learning by adding, to the training data, the data on the laminated substrate and the data on the filler which have been input to the trained model, and the applying condition which has been output from the trained model; and performing machine learning using the updated training data to update the trained model.

In an embodiment, the filler application module includes a substrate holder or a substrate holding device configured to hold the laminated substrate in a vertical posture.

In an embodiment, there is provided a substrate processing apparatus comprising: an arithmetic system having a trained model constructed by machine learning; and a thinning device configured to thin a laminated substrate having a first substrate and a second substrate bonded to each other, wherein the arithmetic system is configured to: input data on the laminated substrate, data on a filler applied to a gap between an edge portion of the first substrate and an edge portion of the second substrate, and data on the thinning device into the trained model constructed by the machine learning; output a thinning condition for the laminated substrate from the trained model; and instruct the thinning device to thin the laminated substrate according to the thinning condition.

In an embodiment, there is provided a computer-readable storage medium storing a program for causing a computer to perform steps of: inputting data on a laminated substrate and data on a filler into a trained model constructed by machine learning, the laminated substrate having a first substrate and a second substrate bonded to each other; outputting an applying condition for the filler from the trained model; and instructing a filler application module to apply the filler to a gap between an edge portion of the first substrate and an edge portion of the second substrate according to the applying condition.

### Advantageous Effects of Invention

According to the present invention, when the filler is applied to the gap between the edge portion of the first substrate and the edge portion of the second substrate, the surface shapes of the edge portion of the first substrate and the edge portion of the second substrate are measured in advance and the applying condition for the filler is determined. As a result, appropriate filling of the filler can be achieved.

Further, according to the present invention, an appropriate applying condition is determined by the trained model, and the filler is applied to the laminated substrate with an appropriate amount according to the applying condition. As a result, cracking or chipping of the knife-edge portion of the laminated substrate can be prevented, and contamination of surrounding environment can be prevented. Furthermore, according to the present invention, an appropriate thinning condition is determined by the trained model, so that the laminated substrate is appropriately thinned according to the thinning condition. As a result, clogging of the grinding tool can be prevented, and a throughput of the thinning process can be improved.

### Brief Description of Drawings

[FIG. 1A] FIG. 1A is an enlarged cross-sectional view showing an edge portion of a substrate;
[FIG. 1B] FIG. 1B is an enlarged cross-sectional view showing an edge portion of a substrate;
[FIG. 2] FIG. 2 is an enlarged cross-sectional view showing a laminated substrate;
[FIG. 3] FIG. 3 is a schematic diagram showing an embodiment of a substrate processing apparatus;
[FIG. 4] FIG. 4 is a diagram showing an embodiment of a measuring method performed by a surface-shape measuring device;
[FIG. 5] FIG. 5 is a diagram showing another embodiment of the measuring method performed by the surface-shape measuring device;
[FIG. 6] FIG. 6 is a plan view showing an embodiment of a filler application module;
[FIG. 7] FIG. 7 is a side view showing an embodiment of the filler application module;
[FIG. 8] FIG. 8 is a schematic diagram showing an embodiment of an application device;
[FIG. 9] FIG. 9 is a diagram illustrating surface shapes of edge portions to be measured by the surface-shape measuring device;
[FIG. 10] FIG. 10 is a schematic diagram showing another embodiment of the substrate processing apparatus;
[FIG. 11] FIG. 11 is a diagram illustrating surface shapes of edge portions to be measured by the surface-shape measuring device before a first substrate and a second substrate are bonded;
[FIG. 12A] FIG. 12A is a cross-sectional view showing an example of an edge portion of a laminated substrate to be processed;
[FIG. 12B] FIG. 12B is a cross-sectional view showing an example of the edge portion of the laminated substrate to which the filler is applied;
[FIG. 12C] FIG. 12C is a cross-sectional view showing an example of the edge portion of the laminated substrate that has been thinned after the filler is applied;
[FIG. 13] FIG. 13 is a schematic diagram showing an embodiment of a substrate processing apparatus;
[FIG. 14] FIG. 14 is a plan view showing an embodiment of a filler application module;
[FIG. 15] FIG. 15 is a side view of the filler application module shown in FIG. 14;
[FIG. 16] FIG. 16 is a schematic diagram showing an embodiment of an application device;
[FIG. 17] FIG. 17 is a conceptual diagram illustrating an embodiment of an operation of an arithmetic system;
[FIG. 18] FIG. 18 is a flowchart illustrating an embodiment of a method of constructing a trained model with machine learning;
[FIG. 19] FIG. 19 is a flowchart illustrating an embodiment of a method of applying a filler to the laminated substrate according to an applying condition determined using the trained model;
[FIG. 20] FIG. 20 is a conceptual diagram illustrating an embodiment of the operation of the arithmetic system;
[FIG. 21] FIG. 21 is a flowchart illustrating an embodiment of the method of constructing the trained model with the machine learning;
[FIG. 22] FIG. 22 is a flowchart illustrating an embodiment of a method of applying the filler to the laminated substrate and curing the filler according to an applying condition and a curing condition determined using the trained model;
[FIG. 23] FIG. 23 is a schematic diagram showing another embodiment of the substrate processing apparatus;
[FIG. 24] FIG. 24 is a schematic diagram showing an embodiment of a thinning apparatus;
[FIG. 25] FIG. 25 is a conceptual diagram illustrating an embodiment of the operation of the arithmetic system;
[FIG. 26] FIG. 26 is a flowchart illustrating an embodiment of the method of constructing the trained model with the machine learning;
[FIG. 27] FIG. 27 is a flowchart illustrating an embodiment of a method of applying the filler to the laminated substrate, curing the filler, and thinning the laminated substrate according to an applying condition, a curing condition, and a thinning condition determined using the trained model;
[FIG. 28] FIG. 28 is a conceptual diagram illustrating an embodiment of the operation of the arithmetic system;
[FIG. 29] FIG. 29 is a flowchart illustrating an embodiment of the method of constructing the trained model with the machine learning;
[FIG. 30] FIG. 30 is a flowchart illustrating an embodiment of a method of thinning the laminated substrate in which the filler has been cured according to a thinning condition determined using the trained model;
[FIG. 31] FIG. 31 is a schematic diagram showing an embodiment of the substrate processing apparatus;
[FIG. 32] FIG. 32 is a schematic diagram showing an embodiment of the substrate processing apparatus;
[FIG. 33] FIG. 33 is a schematic diagram showing an embodiment of the substrate processing apparatus;
[FIG. 34] FIG. 34 is a plan view showing another embodiment of the filler application module;
[FIG. 35] FIG. 35 is a side view of the filler application module shown in FIG. 34;
[FIG. 36] FIG. 36 is a side view showing still another embodiment of the filler application module;
[FIG. 37] FIG. 37 is a diagram as viewed from a direction indicated by an arrow A in FIG. 36;
[FIG. 38] FIG. 38 is a side view showing still another embodiment of the filler application module; and
[FIG. 39] FIG.39 is a diagram as viewed from a direction indicated by an arrow B in FIG. 38.

### Description of Embodiments

Hereinafter, embodiments of the present invention will be described in detail with reference to the drawings.

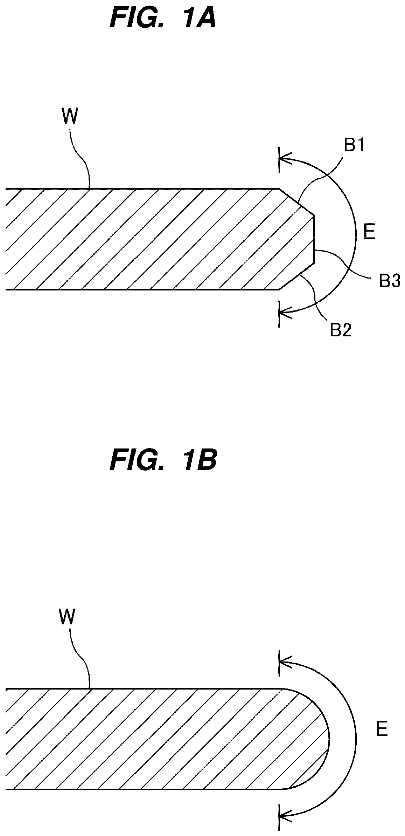

FIGS. 1A and 1B are enlarged cross-sectional views each showing an edge portion E of a substrate W. More specifically, FIG. 1A is a cross-sectional view of a substrate W of a so-called straight type, and FIG. 1B is a cross-sectional view of a substrate W of a so-called round type. The edge portion E is a portion constituting an outermost circumferential surface inclined with respect to a flat surface (a front surface and a back surface) of the substrate W and having a rounded shape or a beveled shape. In the substrate W in FIG. 1A, the edge portion E is an outermost circumferential surface including an upper slope portion (or upper bevel portion) B1, a lower slope portion (or lower bevel portion) B2, and a side portion (or apex) B3 of the substrate W. In the substrate W in FIG. 1B, the edge portion E is a portion constituting an outermost circumferential surface of the substrate W and having a curved cross section. The edge portion E may be also referred to as a bevel portion.

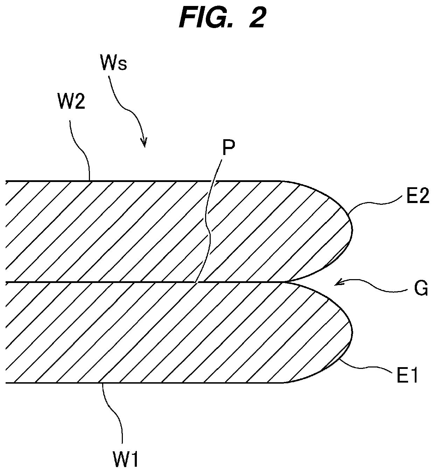

FIG. 2 is an enlarged cross-sectional view showing a laminated substrate Ws. The laminated substrate Ws has a structure in which a first substrate W1 and a second substrate W2 are bonded at a bonding surface P. Each of the first substrate W1 and the second substrate W2 for use in this embodiment has a circular shape. The laminated substrate Ws of this embodiment has a structure in which a first substrate W1 and a second substrate W2 of the round type shown in FIG. 1B are bonded, while in one embodiment, the laminated substrate Ws may have a structure in which a first substrate W1 and a second substrate W2 of the straight type shown in FIG. 1A are bonded. In this specification, the edge portion of the laminated substrate Ws refers to an outer periphery of the laminated substrate Ws including the edge portion E1 of the first substrate W1 and the edge portion E2 of the second substrate W2. The edge portions E1 and E2 may be called bevel portions. A gap G is formed between the edge portion E1 of the first substrate W1 and the edge portion E2 of the second substrate W2. The gap G is formed around the entire circumference of the laminated substrate Ws.

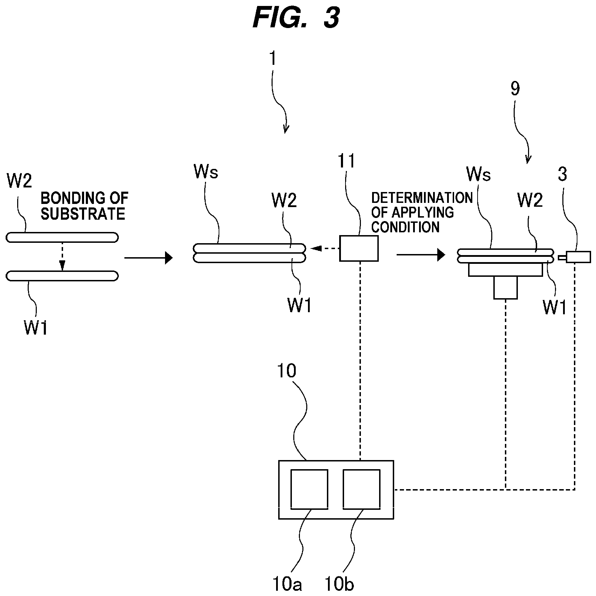

FIG. 3 is a schematic diagram showing an embodiment of a substrate processing apparatus 1. The substrate processing apparatus 1 is an apparatus for determining an applying condition for a filler F in advance and applying the filler F to the laminated substrate Ws having the first substrate W1 and the second substrate W2 which have been bonded. The substrate processing apparatus 1 includes a filler application module 9 configured to apply the filler F to the laminated substrate Ws, a surface-shape measuring device 11 configured to measure surface shapes of the first substrate W1 and the second substrate W2, and an operation controller 10 configured to control operations of the filler application module 9 and the surface-shape measuring device 11.

As shown in FIG. 3, after the first substrate W1 and the second substrate W2 are bonded, the surface-shape measuring device 11 measures surface shapes of the edge portion E1 of the first substrate W1 and the edge portion E2 of the second substrate W2 constituting the laminated substrate Ws. The operation controller 10 then determines the applying condition for the filler F based on the measuring results of the surface shapes. The filler application module 9 applies the filler F to the laminated substrate Ws under the determined applying condition. The surface-shape measuring device 11 may be provided along with a transporting device (not shown) for transporting the laminated substrate Ws to the filler application module 9, and may measure the surface shapes of the edge portion E1 of the first substrate W1 and the edge portion E2 of the second substrate W2 during or before and after transporting of the laminated substrate Ws.

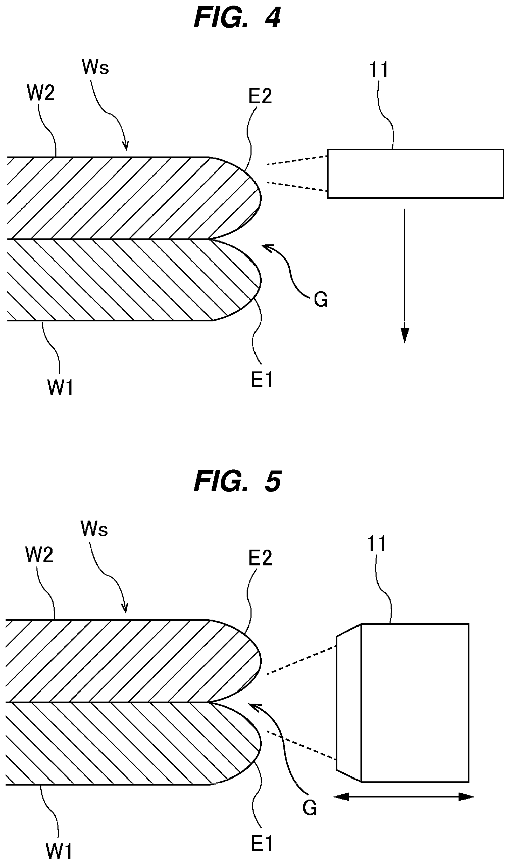

FIG. 4 is a diagram showing an embodiment of a measuring method performed by the surface-shape measuring device 11. The surface-shape measuring device 11 is a laser scanning device which is configured to measure a surface shape (including its dimension) of a measurement target by emitting laser light to the measurement target and detecting laser light reflected from the measurement target. As shown in FIG. 4, the surface-shape measuring device 11 moves in a thickness direction of the laminated substrate Ws while emitting the laser light to the measurement target, so that the surface-shape measuring device 11 scans the edge portion E1 of the first substrate W1 and the edge portion E2 of the second substrate W2 with the laser light to measure the surface shapes of the edge portion E1 of the first substrate W1 and the edge portion E2 of the second substrate W2.

FIG. 5 is a diagram showing another embodiment of the measuring method performed by the surface-shape measuring device 11. The surface-shape measuring device 11 is a confocal laser microscope which is configured to measure a surface shape (including its dimension) of a measurement target by emitting laser light to the measurement target and generating a focal image of the measurement target. As shown in FIG. 5, the surface-shape measuring device 11 moves an objective lens of the confocal laser microscope in a radial direction of the laminated substrate Ws while emitting the laser light to the measurement target, so that the surface-shape measuring device 11 generates focal images of the edge portion E1 of the first substrate W1 and the edge portion E2 of the second substrate W2 to measure the surface shapes of the edge portion E1 of the first substrate W1 and the edge portion E2 of the second substrate W2.

The surface-shape measuring device 11 is not limited to the embodiments described with reference to FIGS. 4 and 5 as long as the surface-shape measuring device 11 can measure the surface shapes of the edge portion E1 of the first substrate W1 and the edge portion E2 of the second substrate W2.

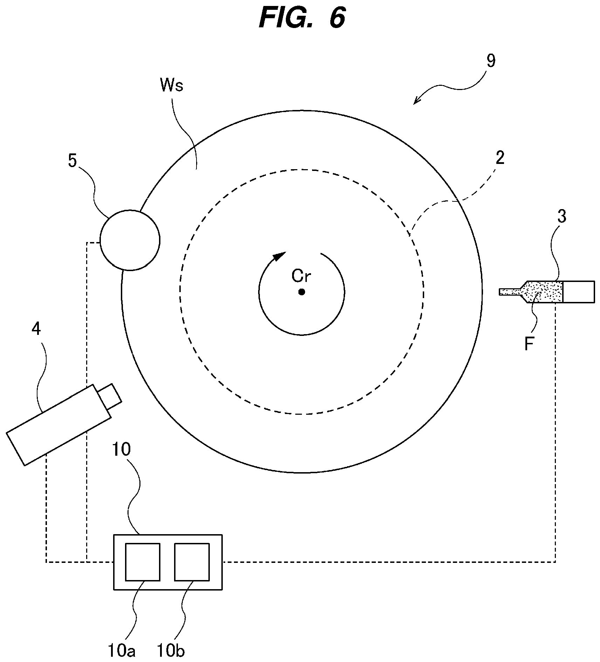

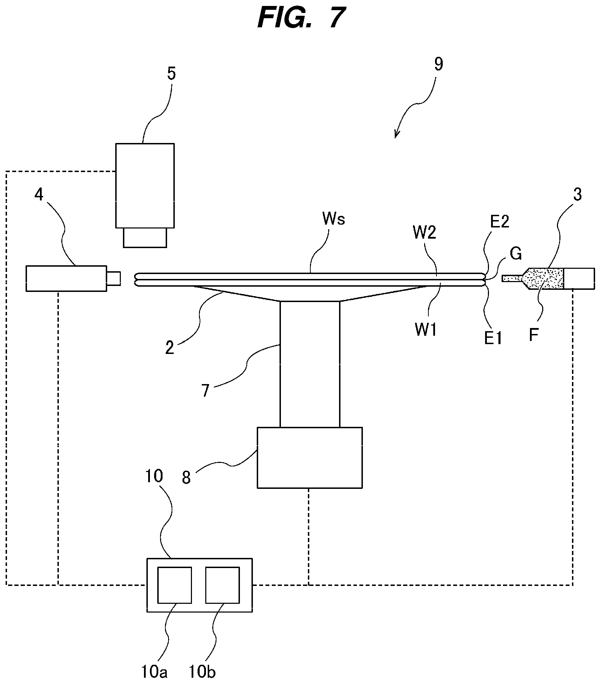

FIG. 6 is a plan view showing an embodiment of the filler application module 9, and FIG. 7 is a side view showing an embodiment of the filler application module 9. The filler application module 9 includes a substrate holder 2 configured to hold the laminated substrate Ws, an application device 3 configured to apply the filler F, and a curing device 4 configured to cure the applied filler F.

The substrate holder 2 includes a stage configured to hold a back surface of the laminated substrate Ws by vacuum suction. The filler application module 9 further includes a rotating shaft 7 coupled to a central portion of the substrate holder 2, and a rotating mechanism 8 configured to rotate the substrate holder 2 and the rotating shaft 7. The laminated substrate Ws is placed on the substrate holder 2 such that the center of the laminated substrate Ws is aligned with a central axis of the rotating shaft 7. The rotating mechanism 8 includes a motor (not shown). As shown in FIG. 6, the rotating mechanism 8 is configured to rotate the substrate holder 2 and the laminated substrate Ws together in a direction shown by an arrow about a central axis Cr of the laminated substrate Ws.

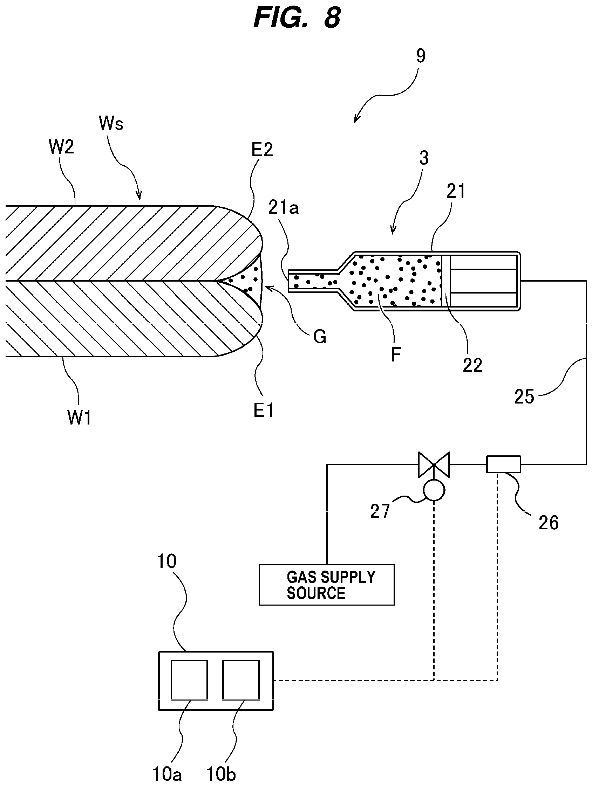

The application device 3 is located radially outwardly of the laminated substrate Ws placed on the substrate holder 2, and is configured to apply the filler F to the gap G between the edge portion E1 of the first substrate W1 and the edge portion E2 of the second substrate W2 of the laminated substrate Ws. FIG. 8 is a schematic diagram showing an embodiment of the application device 3. The application device 3 includes a syringe 21 for injecting the filler F, a piston 22 movable reciprocally in the syringe 21, and a horizontal moving mechanism (not shown) configured to move the syringe 21 toward and away from the laminated substrate Ws. This horizontal moving mechanism allows the application device 3 to adjust a distance between the laminated substrate Ws and a filler emitting port 21a of the application device 3. In one embodiment, the application device 3 may omit the horizontal moving mechanism. In this case, the distance between the laminated substrate Ws and the filler emitting port 21a is determined in advance such that the filler F is appropriately injected into the gap G of the laminated substrate Ws.

The syringe 21 has a hollow structure and is configured to be filled with the filler F therein. The piston 22 is arranged in the syringe 21. The syringe 21 has the filler emitting port 21a for emitting the filler F at its tip. The tip of the syringe 21 including the filler emitting port 21a may be configured to be detachable. A shape of the filler emitting port 21a is selected to be an appropriate shape depending on physical properties (e.g., viscosity, etc.) of the filler F to be applied. The filler emitting port 21a is arranged so as to face the gap G between the edge portion E1 of the first substrate W1 and the edge portion E2 of the second substrate W2.

The application device 3 is coupled to a gas supply source via a gas supply line 25. When gas (e.g., dry air or nitrogen gas) is supplied from the gas supply source into the syringe 21, the piston 22 moves forward in the syringe 21. The forward movement of the piston 22 causes the filler F in the syringe 21 to be emitted through the filler emitting port 21a. The application device 3 continuously applies the filler F into the gap G formed in the edge portion of the rotating laminated substrate Ws. The filler F may be applied while the laminated substrate Ws rotates multiple times depending on a total amount of the filler F to be applied.

A pressure regulator 26 and an on-off valve 27 are disposed in the gas supply line 25. The on-off valve 27 is an actuator-driven valve, such as an electric valve or a solenoid valve. When the on-off valve 27 is opened, the gas is supplied from the gas supply source to the application device 3, so that the application device 3 applies the filler F to the laminated substrate Ws. When the on-off valve 27 is closed, the supply of the gas to the application device 3 is stopped, so that the applying of the filler F is stopped. The pressure regulator 26 can regulate an amount of the filler F to be emitted from the filler emitting port 21a per unit time by regulating a pressure of the gas to be supplied from the gas supply source to the application device 3. Operations of the pressure regulator 26 and the on-off valve 27 are controlled by the operation controller 10.

In one embodiment, the application device 3 may include a screw feeder instead of the combination of the syringe 21 and the piston 22.

As shown in FIGS. 6 and 7, the curing device 4 is located radially outwardly of the laminated substrate Ws placed on the substrate holder 2. The curing device 4 is disposed downstream of the application device 3 in a rotating direction of the laminated substrate Ws, and is configured to cure the filler F that has been applied to the laminated substrate Ws by the application device 3. Curing of the filler F by the curing device 4 is performed while the laminated substrate Ws is rotated. In this embodiment, the filler F has thermosetting property. An example of such filler is a thermosetting resin.

The curing device 4 is an air heater, which is configured to emit hot air blowing toward the filler F applied to the laminated substrate Ws. The curing device 4 is configured to be able to regulate pressure and temperature of the hot air blowing toward the filler F. The filler F heated with the hot air is cured by a crosslinking reaction. The curing device 4 continuously cures the filler F applied to the edge portion of the rotating laminated substrate Ws. When the filler F contains a solvent, the solvent is volatilized by being heated. The curing device 4 is not limited to the air heater, and may be a lamp heater or other configuration as long as the curing device 4 can heat and cure the filler F.

In this embodiment, the filler F has thermosetting property, while in one embodiment, the filler F may have ultraviolet curable property. In this case, the curing device 4 may be a UV irradiation device configured to cure the filler F by emitting ultraviolet ray. When the filler F contains a solvent, the curing device 4 may heat the filler F to volatilize the solvent with an air heater or the like, in addition to the UV irradiation device.

The filler application module 9 may further include an infrared imaging device 5 configured to generate an image of the edge portion of the laminated substrate Ws. The infrared imaging device 5 is disposed downstream of the curing device 4 in the rotating direction of the laminated substrate Ws. The infrared imaging device 5 is configured to generate an image including the filler F applied to the laminated substrate Ws by the application device 3 and cured by the curing device 4. A distance between the infrared imaging device 5 and the curing device 4 is shorter than a distance between the infrared imaging device 5 and the application device 3. The infrared imaging device 5 is located above the edge portion of the laminated substrate Ws, and is configured to generate an image of the edge portion of the laminated substrate Ws. More specifically, the infrared imaging device 5 emits infrared light to the edge portion of the laminated substrate Ws, receives infrared light reflected from the edge portion of the laminated substrate Ws, and generates the image of the edge portion of the laminated substrate Ws. An example of the infrared imaging device 5 is an infrared microscope.

In this embodiment, the first substrate W1 and the second substrate W2 are basically made of silicon wafers, and the infrared light emitted from the infrared imaging device 5 is transmitted through the first substrate W1 and the second substrate W2. Since the infrared light do not pass through the filler F, the infrared imaging device 5 can generate the image of the filler F applied to the laminated substrate Ws from the infrared light reflected from the edge portion of the laminated substrate Ws.

The operation controller 10 is configured to control operations of the substrate processing apparatus 1 including the filler application module 9 and the surface-shape measuring device 11 configured as described above. The filler application module 9, which includes the application device 3, the curing device 4, the infrared imaging device 5, the rotating mechanism 8, the pressure regulator 26, and the on-off valve 27, and the surface-shape measuring device 11 are electrically coupled to the operation controller 10.

The operation controller 10 is composed of at least one computer. The operation controller 10 includes a memory 10a storing programs therein for controlling the operations of the substrate processing apparatus 1 including the filler application module 9 and the surface-shape measuring device 11, and a processor 10b configured to perform arithmetic operations according to instructions contained in the programs. The memory 10a includes a main memory, such as a random-access memory (RAM), and an auxiliary memory, such as a hard disk drive (HDD) or a solid state drive (SSD). Examples of the processor 10b include a CPU (central processing unit) and a GPU (graphic processing unit). However, the specific configuration of the operation controller 10 is not limited to these examples.

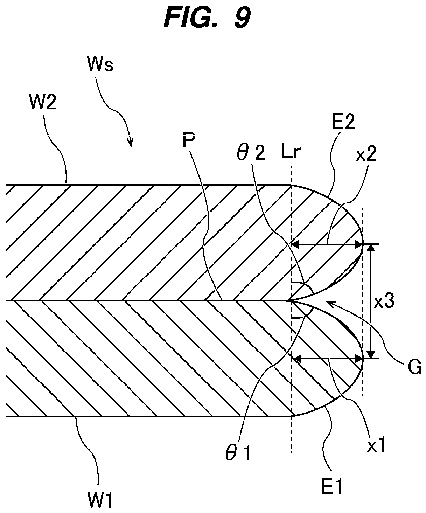

The operation controller 10 instructs the surface-shape measuring device 11 to measure the surface shapes of the edge portion E1 of the first substrate W1 and the edge portion E2 of the second substrate W2. The operation controller 10 determines an applying condition for the filler F to be applied to the laminated substrate Ws based on the measuring results of the surface shapes. FIG. 9 is a diagram illustrating the surface shapes of the edge portions to be measured by the surface-shape measuring device 11. The surface shapes of the edge portion E1 of the first substrate W1 and the edge portion E2 of the second substrate W2 to be measured are specified by at least one of: (i) a dimension x1 of the edge portion E1 in a radial direction of the first substrate W1 and a dimension x2 of the edge portion E2 in a radial direction of the second substrate W2; (ii) a dimension x3 of the gap G in a thickness direction of the gap G between the edge portion E1 of the first substrate W1 and the edge portion E2 of the second substrate W2; and (iii) an inclination angle θ1 of the edge portion E1 of the first substrate W1 and an inclination angle θ2 of the edge portion E2 of the second substrate W2.

A reference line Lr shown in FIG. 9 is perpendicular to the bonding surface P of the first substrate W1 and the second substrate W2, and passes through a radially-outermost end of the bonding surface P. The radially-outermost end of the bonding surface P coincides with a radially-innermost end of the gap G between the edge portion E1 of the first substrate W1 and the edge portion E2 of the second substrate W2. The dimension x1 of the edge portion E1 in the radial direction of the first substrate W1 is a distance from the reference line Lr to a radially-outermost end of the first substrate W1. The dimension x2 of the edge portion E2 in the radial direction of the second substrate W2 is a distance from the reference line Lr to a a radially-outermost end of the second substrate W2. In one embodiment, if the first substrate W1 and the second substrate W2 have the same shape, either the dimension x1 or the dimension x2 may be measured.

The dimension x3 of the gap G in the thickness direction of the gap G between the edge portion E1 of the first substrate W1 and the edge portion E2 of the second substrate W2 is a distance in the thickness direction of the laminated substrate Ws (the first substrate W1 and the second substrate W2) from the radially-outermost end of the first substrate W1 to the radially-outermost end of the second substrate W2. The inclination angle θ1 of the edge portion E1 of the first substrate W1 is an angle of the edge portion E1 of the first substrate W1 with respect to the reference line Lr. The inclination angle θ2 of the edge portion E2 of the second substrate W2 is an angle of the edge portion E2 of the second substrate W2 with respect to the reference line Lr. In one embodiment, if the first substrate W1 and the second substrate W2 have the same shape, either the inclination angle θ1 or the inclination angle θ2 may be measured. In one embodiment, the inclination angle θ1 and the inclination angle θ2 may be angles of the edge portion E1 of the first substrate W1 and the edge portion E2 of the second substrate W2 with respect to the bonding surface P of the first substrate W1 and the second substrate W2, respectively.

The operation controller 10 determines the applying condition for the filler F to be applied by the filler application module 9 based on the measuring results of the surface shapes (i.e., the dimensions x1, x2, and x3 and the inclination angles θ1 and θ2) described with reference to FIG. 9. The applying condition includes at least one of a composition of the filler F, a total amount of the filler F to be applied, a shape of the filler emitting port 21a of the application device 3, a distance between the laminated substrate Ws and the filler emitting port 21a, an amount of the filler F to be emitted from the filler emitting port 21a per unit time, wind pressure and temperature of the hot air to be emitted from the curing device 4, and a rotation speed of the laminated substrate Ws.

The filler F is mainly composed of a binder, a solvent, and particles. The particles are dispersed in the binder dissolved in the solvent. The particles are used in order to increase a volume of the filler and to adjust a viscosity of the filler. If the viscosity of the filler F is high and the diameter of the particles is large, the filler F may not enter the minute gap G, and as a result, a failure of filling may occur. Thus, the operation controller 10 determines an appropriate composition of the filler F based on the measuring results of the surface shapes described with reference to FIG. 9. More specifically, the composition of the filler F includes a type of the binder, an amount of the solvent, an amount of the particles, and a size of the particles.

The operation controller 10 determines the total amount of the filler F to be applied (a volume of the filler F) based on the measuring results of the surface shapes described with reference to FIG. 9. The shape of the filler emitting port 21a of the application device 3, the distance between the laminated substrate Ws and the filler emitting port 21a, the amount of the filler F to be emitted from the filler emitting port 21a per unit time, the wind pressure and the temperature of the hot air to be emitted from the curing device 4, and the rotation speed of the laminated substrate Ws may be determined based on the determined composition of the filler F. The operation controller 10 instructs the filler application module 9 to cause the application device 3 to apply the filler F under the determined applying condition, and to cause the curing device 4 to cure the applied filler F.

According to this embodiment, when the filler F is to be applied to the gap G of the laminated substrate Ws, the surface shapes of the edge portion E1 of the first substrate W1 and the edge portion E2 of the second substrate W2 are measured in advance, and the applying condition for the filler F is determined. As a result, appropriate filling of the filler F can be achieved.

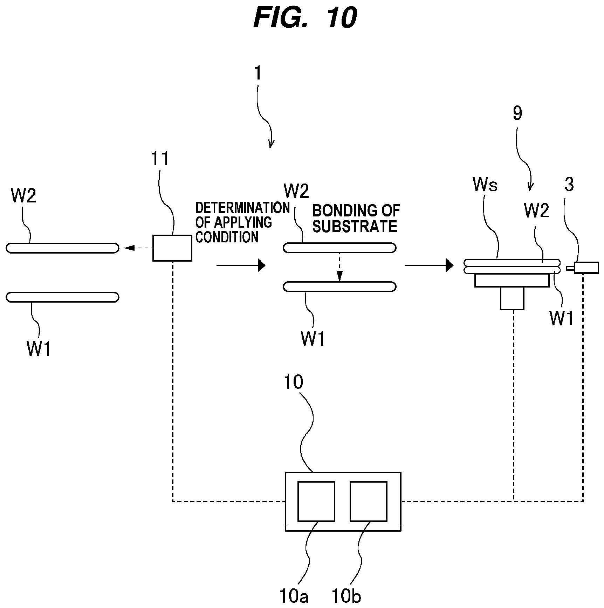

FIG. 10 is a schematic diagram showing another embodiment of the substrate processing apparatus 1. In this embodiment, before the first substrate W1 and the second substrate W2 are bonded, the operation controller 10 instructs the surface-shape measuring device 11 to measure the surface shapes of the edge portion E1 of the first substrate W1 and the edge portion E2 of the second substrate W2. The operation controller 10 then determines the applying condition for the filler F based on the measuring results of the surface shapes. After the first substrate W1 and the second substrate W2 are bonded, the operation controller 10 instructs the filler application module 9 to apply the filler F by the application device 3 under the determined applying condition, and to cure the applied filler F by the curing device 4.

The surface shapes of the edge portion E1 of the first substrate W1 and the edge portion E2 of the second substrate W2 to be measured are specified by at least one of: (i) a dimension x1 of the edge portion E1 in the radial direction of the first substrate W1 and a dimension x2 of the edge portion E2 in the radial direction of the second substrate W2; (ii) a dimension x3 of the gap G in the thickness direction of the gap G between the edge portion E1 of the first substrate W1 and the edge portion E2 of the second substrate W2; and (iii) an inclination angle θ1 of the edge portion E1 of the first substrate W1 and an inclination angle θ2 of the edge portion E2 of the second substrate W2.

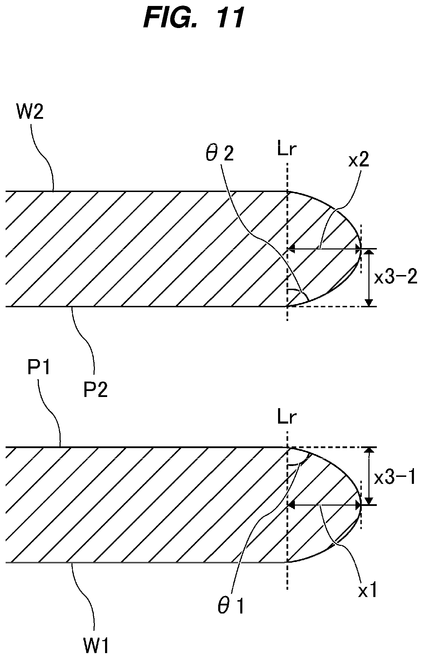

FIG. 11 is a diagram illustrating the surface shapes of the edge portions to be measured by the surface-shape measuring device 11 before the first substrate W1 and the second substrate W2 are bonded. When the first substrate W1 and the second substrate W2 are bonded, a bonding surface P1 of the first substrate W1 is bonded to a bonding surface P2 of the second substrate W2. The dimensions x1 and x2, and the inclination angles θ1 and θ2 in FIG. 11 are the same as the dimensions x1 and x2, and the inclination angles θ1 and θ2 described with reference to FIG. 9, and duplicated descriptions will be omitted.

The dimension x3 of the gap G in the thickness direction of the gap G between the edge portion E1 of the first substrate W1 and the edge portion E2 of the second substrate W2 is the sum of a dimension x3-1 and a dimension x3-2 shown in FIG. 11. The dimension x3-1 is a distance in a thickness direction from the radially-outermost end of the first substrate W1 to the bonding surface P1. The dimension x3-2 is a distance in a thickness direction from the radially-outermost end of the second substrate W2 to the bonding surface P2. In one embodiment, if the first substrate W1 and the second substrate W2 have the same shape, either the dimension x3-1 or the dimension x3-2 may be measured, and twice the measured value may be determined to the dimension x3 of the gap G in the thickness direction of the gap G between the edge portion E1 of the first substrate W1 and the edge portion E2 of the second substrate W2.

Hereinafter, embodiments of the present invention will be described in detail with reference to the drawings.

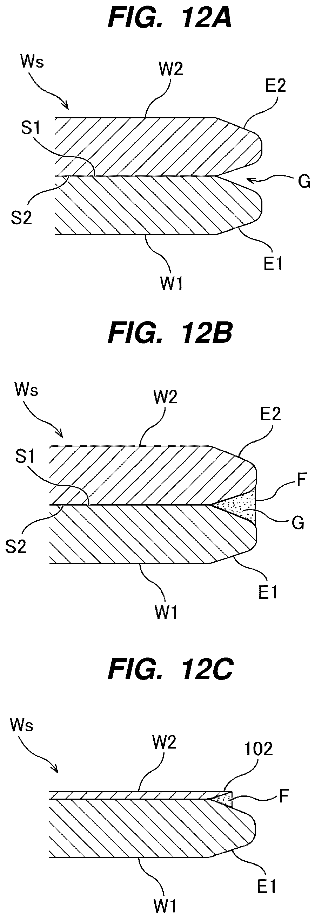

FIG. 12A is a cross-sectional view showing an example of an edge portion of a laminated substrate to be processed. As shown in FIG. 12A, a laminated substrate Ws includes a first substrate W1 and a second substrate W2 which have been bonded. Each of the first substrate W1 and the second substrate W2 for use in this embodiment has a circular shape.

An edge portion E1 of the first substrate W1 is a portion constituting an outermost circumferential surface inclined with respect to a bonding surface (e.g., a device surface) S1 of the first substrate W1. More specifically, the edge portion E1 of the first substrate W1 has a rounded shape or a beveled shape. Similarly, an edge portion E2 of the second substrate W2 is a portion constituting an outermost circumferential surface inclined with respect to a bonding surface (e.g., a device surface) S2 of the second substrate W2. More specifically, the edge portion E2 of the second substrate W2 has a rounded shape or a beveled shape. Each of the edge portions E1 and E2 may be referred to a bevel portion. A gap G is formed between the edge portion E1 of the first substrate W1 and the edge portion E2 of the second substrate W2.

FIG. 12B is a cross-sectional view showing an example of the edge portion of the laminated substrate Ws to which filler F is applied. The filler F is applied to the gap G between the edge portion E1 of the first substrate W1 and the edge portion E2 of the second substrate W2. This gap G is formed around the entire circumference of the laminated substrate Ws, and has an approximately triangular cross section. The filler F is applied so as to fill this gap G.

FIG. 12C is a cross-sectional view showing an example of the edge portion of the laminated substrate Ws that has been thinned after the filler F is applied. In the example shown in FIG. 12C, thinning of the laminated substrate Ws is performed by grinding an outer side surface of the second substrate W2 with a thinning device (not shown). As a result of this thinning process, a knife-edge portion 102 is formed in the edge portion E2 of the second substrate W2. Since the knife-edge portion 102 is held (supported) by the filler F, the knife-edge portion 102 is prevented from cracking or chipping.

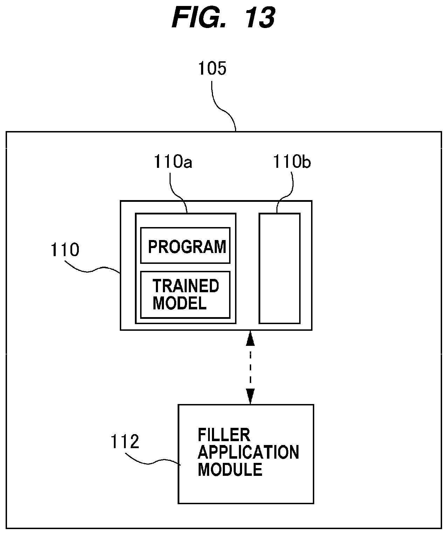

FIG. 13 is a schematic diagram showing an embodiment of a substrate processing apparatus 105. The substrate processing apparatus 105 of this embodiment includes an arithmetic system 110 having a trained model constructed by machine learning, and a filler application module 112 configured to apply a filler to a laminated substrate having a first substrate and a second substrate which have been bonded. Although the laminated substrate is not depicted in FIG. 13, the laminated substrate has the configuration described with reference to FIGS. 12A to 12C. The arithmetic system 110 is configured to not only calculate an applying condition for the filler according to an algorithm defined by the trained model as described below, but also to control operations of the filler application module 112.

The arithmetic system 110 includes a memory 110a storing programs and the trained model therein, and an arithmetic device 110b configured to perform arithmetic operations according to instructions contained in the programs. The memory 110a includes a main memory, such as a random-access memory (RAM), and an auxiliary memory, such as a hard disk drive (HDD) or a solid state drive (SSD). Examples of the arithmetic device 110b include a CPU (central processing unit) and a GPU (graphic processing unit). However, the specific configuration of the arithmetic system 110 is not limited to these examples.

The arithmetic system 110 is comprised of at least one computer. The at least one computer may be one server or multiple servers. The arithmetic system 110 may be an edge server coupled to the filler application module 112 by a communication line, or a cloud server or a fog server coupled to the filler application module 112 by a communication network, such as the Internet or a local area network.

The arithmetic system 110 may be multiple computers coupled by a communications network, such as the Internet or a local area network. For example, the arithmetic system 110 may be a combination of an edge server and a cloud server. The memory 110a and the arithmetic device 110b may be disposed in multiple computers installed at different locations, respectively. Furthermore, the arithmetic system 110 may include a first computer for constructing a trained model by machine learning, and a second computer for calculating the applying condition with the trained model. The first computer and the second computer may be disposed in separated locations.

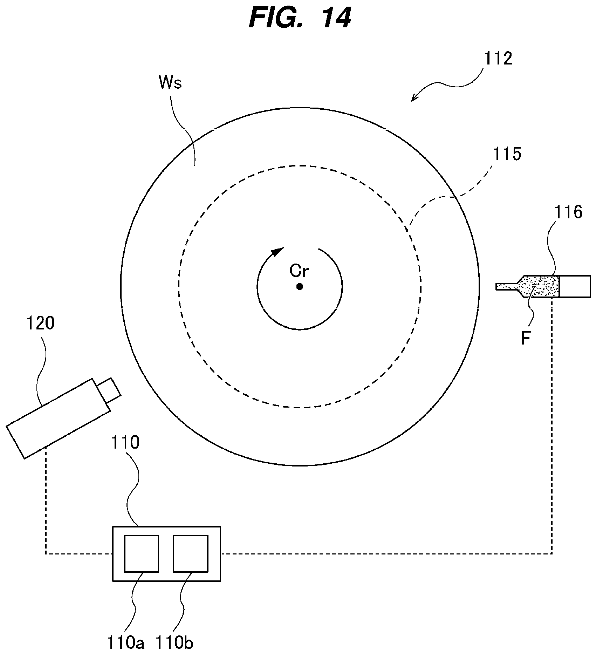

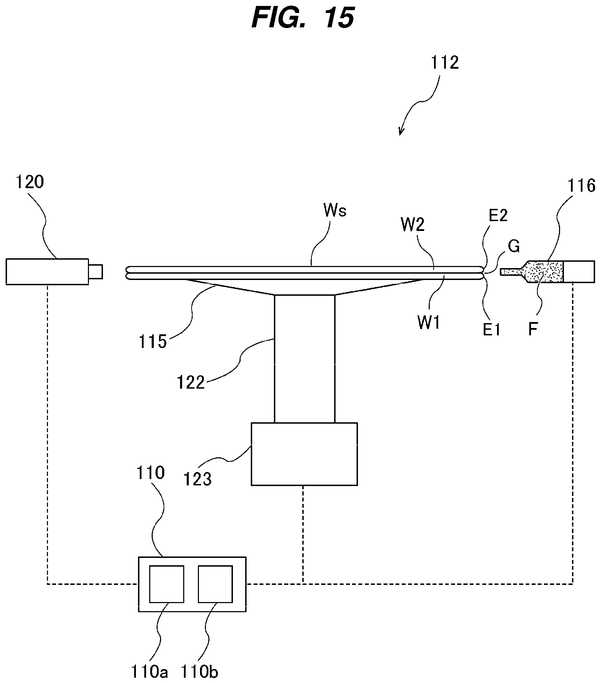

FIG. 14 is a plan view of an embodiment of the filler application module 112, and FIG. 15 is a side view of the filler application module 112 shown in FIG. 14. The filler application module 112 is configured to apply a filler to the edge portion of the laminated substrate Ws while rotating the laminated substrate Ws. The filler application module 112 includes a substrate holder 115 configured to hold the laminated substrate Ws, an application device 116 configured to apply a filler F to the edge portion of the laminated substrate Ws, and a curing device 120 configured to cure the applied filler F.

The substrate holder 115 includes a stage configured to hold a back surface of the laminated substrate Ws by vacuum suction. The filler application module 112 further includes a rotating shaft 122 coupled to a central portion of the substrate holder 115, and a rotating mechanism 123 configured to rotate the substrate holder 115 and the rotating shaft 122. The laminated substrate Ws is placed on the substrate holder 115 such that the center of the laminated substrate Ws is aligned with a central axis of the rotating shaft 122. The rotating mechanism 123 includes a motor (not shown). As shown in FIG. 14, the rotating mechanism 123 is configured to rotate the substrate holder 115 and the laminated substrate Ws together in a direction shown by an arrow about a central axis Cr of the laminated substrate Ws.

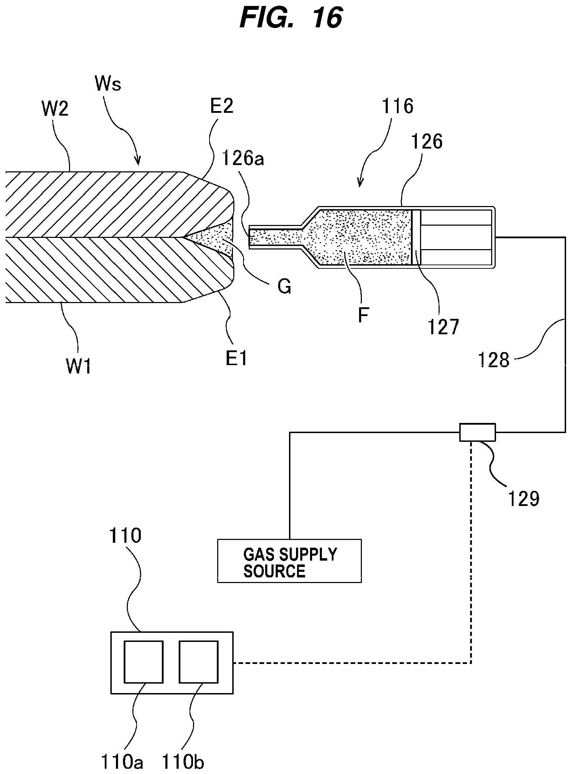

The application device 116 is located radially outwardly of the laminated substrate Ws placed on the substrate holder 115, and is configured to apply the filler F to the gap G between the edge portion E1 of the first substrate W1 and the edge portion E2 of the second substrate W2 of the laminated substrate Ws. FIG. 16 is a schematic diagram showing an embodiment of the application device 116. The application device 116 includes a syringe 126 for injecting the filler F, a piston 127 movable reciprocally in the syringe 126, and a horizontal moving mechanism (not shown) configured to move the syringe 126 toward and away from the laminated substrate Ws. This horizontal moving mechanism allows the application device 116 to adjust a distance between the laminated substrate Ws and a filler emitting port 126a of the application device 116. In one embodiment, the application device 116 may omit the horizontal moving mechanism. In this case, the distance between the laminated substrate Ws and the filler emitting port 126a is determined in advance such that the filler F is appropriately injected into the gap G of the laminated substrate Ws.

The syringe 126 has a hollow structure and is configured to be filled with the filler F therein. The piston 127 is arranged in the syringe 126. The syringe 126 has the filler emitting port 126a for emitting the filler F at its tip. The tip of the syringe 126 including the filler emitting port 126a may be configured to be detachable. A shape of the filler emitting port 126a is selected to be an appropriate shape depending on physical properties (e.g., viscosity, etc.) of the filler F to be applied. The filler emitting port 126a is arranged so as to face the gap G between the edge portion E1 of the first substrate W1 and the edge portion E2 of the second substrate W2.

The application device 116 is coupled to a gas supply source via a gas supply line 128. When gas (e.g., dry air or nitrogen gas) is supplied from the gas supply source to the syringe 126, the piston 127 moves forward in the syringe 126. The forward movement of the piston 127 causes the filler F in the syringe 126 to be emitted from the filler emitting port 126a.

A pressure regulator 129 is disposed in the gas supply line 128. An amount of the filler F to be emitted from the filler emitting port 126a per unit time can be regulated by regulating a pressure of the gas to be supplied from the gas supply source to the application device 116.

In one embodiment, the application device 116 may include a screw feeder instead of the combination of the syringe 126 and the piston 127.

As shown in FIGS. 14 and 15, the curing device 120 is located radially outwardly of the laminated substrate Ws. The curing device 120 is disposed downstream of the application device 116 in a rotating direction of the laminated substrate Ws, and is configured to cure the filler F that has been applied to the laminated substrate Ws by the application device 116. Curing of the filler F by the curing device 120 is performed while the laminated substrate Ws is rotated. In this embodiment, the filler F has thermosetting property. An example of such filler is thermosetting resin.

The curing device 120 is an air heater, which is configured to emit hot air blowing toward the filler F applied to the laminated substrate Ws. The filler F heated with the hot air is cured by a crosslinking reaction. When the filler F contains a solvent, the solvent is volatilized by the heating. The curing device 120 is not limited to the air heater, and may be a lamp heater or other configuration as long as the curing device 120 can heat and cure the filler F.

In this embodiment, the filler F has thermosetting property, while in one embodiment, the filler F may have ultraviolet curable property. In this case, the curing device 120 may be a UV irradiation device configured to cure the filler F by emitting ultraviolet ray. When the filler F contains a solvent, the curing device 120 may heat the filler F to volatilize the solvent with an air heater or the like, in addition to the UV irradiation device.

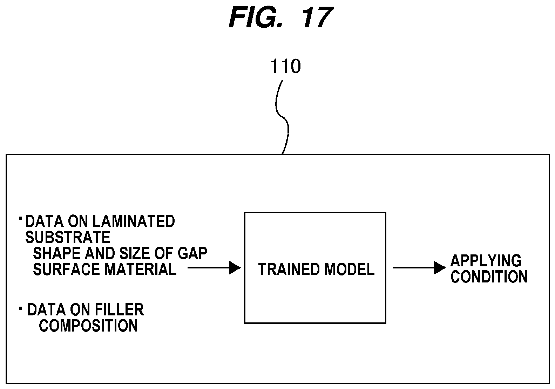

The filler application module 112 is configured to apply the filler F to the laminated substrate Ws according to the applying condition determined by the arithmetic system 110. The arithmetic system 110 determines the applying condition with the trained model stored in the memory 110a as follows. As shown in FIG. 17, the arithmetic system 110 inputs data on the laminated substrate Ws and data on the filler F into the trained model, and outputs the applying condition for the filler F from the trained model. The trained model is created in advance by machine learning with training data.

The data on the laminated substrate Ws include materials constituting surfaces of the first substrate W1 and the second substrate W2, and a shape and a size of the gap G between the edge portion E1 of the first substrate W1 and the edge portion E2 of the second substrate W2. In the following descriptions, the gap G between the edge portion E1 of the first substrate W1 and the edge portion E2 of the second substrate W2 will be referred to as the gap G formed at the edge portion of the laminated substrate Ws, or simply the gap G of the laminated substrate Ws. The shape and the size of the gap G of the laminated substrate Ws affect the amount of the filler F to be applied.

Examples of materials constituting the surfaces of the first substrate W1 and the second substrate W2 include silicon, an insulating film, a metal film, or a combination thereof. The materials constituting the surfaces of the first substrate W1 and the second substrate W2 affect an ease of entry of the filler F into the gap G. The data on the laminated substrate Ws can be obtained from manufacturing information of the laminated substrate Ws, information on a previous process, or the like.

The shape and the size of the gap G of the laminated substrate Ws are specified by an image of the gap G or dimensions of the gap G. The dimensions of the gap G are, for example, a width of the gap G in the radial direction, a height of the gap G, and an angle of an inner end of the gap G (e.g., an angle of a contact portion of the edge portion E1 of the first substrate W1 and the edge portion E2 of the second substrate W2). The shape and the size of the gap G can be measured with a known surface-shape measuring device, such as a laser scanning device or a confocal microscope. In one embodiment, the substrate processing apparatus 105 may include a surface-shape measuring device configured to measure the shape and the size (dimensions) of the gap G formed at the edge portion of the laminated substrate Ws. The shape and the size of the gap G are measured before the filler F is applied to the laminated substrate Ws. Instead of the dimensions of the gap G, an image showing the shape and the size of the gap G may be used. In one embodiment, the substrate processing apparatus 105 may include an imaging device configured to generate the image showing the shape and the size of the gap G.

The data on the filler F include a composition of the filler F. The filler F includes a binder, a solvent, and particles. The particles are dispersed in the binder dissolved in the solvent. For example, the composition of the filler F includes a type of the binder, an amount of the solvent, an amount of the particles, and a size of the particles. Examples of the binder include an inorganic binder containing alkali metal silicate, an organic binder made of silicone resin or epoxy resin, and an inorganic-organic hybrid binder. The particles are, for example, particles of silica or alumina. The particles are incorporated into the binder to increase a volume of the filler F and to adjust a viscosity of the filler F. In order to reduce the viscosity of the filler F, the particles may not be included in the filler F.

Generally, the filler F has a certain degree of viscosity. The viscosity of the filler F depends on the amount of the solvent, the amount of the particles, and the material of the binder. When the filler F contains the solvent, the solvent is volatilized by being heated. Therefore, when the curing process for the filler F is performed after the filler F is applied to the laminated substrate Ws, the volume of the filler F is likely to decrease due to volatilization of the solvent. Thus, in order to determine the appropriate amount of the filler F to fill the gap G formed in the edge portion of the laminated substrate Ws, the viscosity of the filler F, i.e., the composition of the filler F (e.g., the material of the binder, the amount of the solvent, and the amount of the particles) is required. Examples of the amount of the particles include a case where the amount of the particles is 0, i.e., a case where no particles are included.

The data on the laminated substrate Ws and the data on the filler F are input into the arithmetic system 110 and are stored in the memory 110a.

The applying condition output from the trained model includes at least one of a total amount of the filler F to be applied, an amount of the filler F to be applied per unit time, temperature of the filler F, and a rotation speed of the laminated substrate Ws. The total amount of the filler F to be applied is an appropriate amount of the filler F to fill the gap G of the laminated substrate Ws. The amount of the filler F to be applied per unit time is, in other words, an application speed, and is an amount of the filler F to be emitted per unit time from the application device 116 shown in FIGS. 14 to 16. The amount of the filler F to be applied per unit time can be controlled by an extrusion force of the application device 116 on the filler F. The rotation speed of the laminated substrate Ws corresponds to the rotation speed of the substrate holder 115 shown in FIGS. 14 and 15, and can be controlled by the rotating mechanism 123.

The arithmetic system 110 instructs the filler application module 112 to apply the filler F to the gap G between the edge portion E1 of the first substrate W1 and the edge portion E2 of the second substrate W2 according to the above-described applying condition.

A program for constructing the trained model according to a machine-learning algorithm is stored in the memory 110a. The arithmetic device 110b performs the machine learning using training data according to instructions contained in the program to construct the trained model. Examples of the machine-learning algorithm include SVR method (support vector regression method), PLS method (partial least squares method), deep learning method, random forest method, decision tree method, etc. In one example, the trained model is constituted of a neural network constructed by the deep learning method. Constructing the trained model by the machine learning includes optimizing parameters, such as weights of the neural network.

The training data for use in the machine learning include data on laminated substrates, data on fillers, and applying conditions as ground-truth labels. The laminated substrates are laminated substrates actually used for applying the filler. In the following descriptions, these laminated substrates will be referred to as learning laminated substrates. The learning laminated substrates include laminated substrates having different configurations. The different configurations mean configurations in which at least one of the size of the gap in the edge portion, the shape of the gap in the edge portion, and the material constituting the surfaces is different. For example, the learning laminated substrates include learning laminated substrates with different shapes and sizes (or dimensions) of the gap formed in the edge portion, and learning laminated substrates with different materials constituting the surfaces of the first substrate and the second substrate.

The fillers are fillers actually applied to the learning laminated substrates. In the following descriptions, these fillers will be referred to as learning fillers. The learning fillers include fillers having different compositions. The different compositions mean different materials and/or different amounts of at least one of components constituting the filler. For example, the learning fillers include learning fillers with different materials of binder, learning fillers with different amounts of solvent, and learning fillers with different amounts of particles (including no particles).

The applying conditions as the ground-truth labels are applying conditions when good application results for the filler have been obtained. More specifically, the applying conditions as the ground-truth labels are applying conditions when the learning fillers have been actually applied to the learning laminated substrates and good application results have been obtained. The applying conditions as the ground-truth labels include at least one of total amounts of the learning fillers applied, amounts of the learning fillers applied per unit time, temperatures of the learning fillers, and rotation speeds of the learning laminated substrates. The applying conditions as the ground-truth labels include applying conditions that are different from each other. For example, the different applying conditions include at least one of different total amounts of the learning fillers applied, different amounts of the learning fillers applied per unit time, different temperatures of the learning fillers, and different rotation speeds of the learning laminated substrates.

As described above, the ground-truth labels are the applying conditions when good application results have been obtained. Whether the applied state of the learning filler is good or not is determined by observing the edge portion of the learning laminated substrate to which the learning filler has been actually applied. Specifically, after the learning filler is applied, the learning laminated substrate is thinned, and the applied state of the learning filler can be determined based on the number or size of cracking or chipping that has occurred in the knife-edge portion (see reference numeral 102 in FIG. 12C) of the learning laminated substrate. For example, when the number of chippings in the knife-edge portion is less than a threshold value or the size of chipping in the knife-edge portion is smaller than a threshold value (including when no chippings have occurred in the knife-edge portion), the applied state of the learning filler is determined to be good.

In another example, an image of the edge portion of the learning laminated substrate to which the learning filler has been applied is generated by an infrared microscope, and the applied state of the learning filler can be determined based on a size of the learning filler in a target region on the image. More specifically, when an area or a width of the learning filler in the target region is larger than a threshold value, the applied state of the learning filler is determined to be good. The target region is an observation region set in advance on the image.

The infrared microscope is configured to emit infrared light to the edge portion of the learning laminated substrate and generate an image from the infrared light transmitted through or reflected from the edge portion of the learning laminated substrate. The infrared light is transmitted through the first substrate and second substrates made of silicon, while the infrared light is reflected by the filler. As a result, the filler applied to the gap of the learning laminated substrate appears in the image generated by the infrared microscope. Therefore, the applied state of the learning filler can be determined based on the image generated by the infrared microscope.

In still another example, the learning laminated substrate to which the learning filler is applied is cut, and the applied state of the learning filler is determined by visually observing the edge portion of the learning laminated substrate.

The applying condition under which a good applied state of the learning filler (i.e., a good application result) has been obtained is the learning applying condition as a ground-truth label, which is associated (linked) with the data on the corresponding learning laminated substrate and the data on the corresponding learning filler. The ground-truth label is included in the training data together with the data on the corresponding learning laminated substrate and the data on the corresponding learning filler. The training data is also called learning data or teaching data.

In the machine learning, when the data on the learning laminated substrate and the data on the learning filler are input to a model, parameters (e.g. weight) of the model are adjusted such that the applying condition as the ground-truth label is output from the model. The data on the learning laminated substrate and the data on the learning filler are explanatory variables, and the applying condition is objective variable. The arithmetic system 110 stores the trained model constructed by the machine learning in the memory 110a.

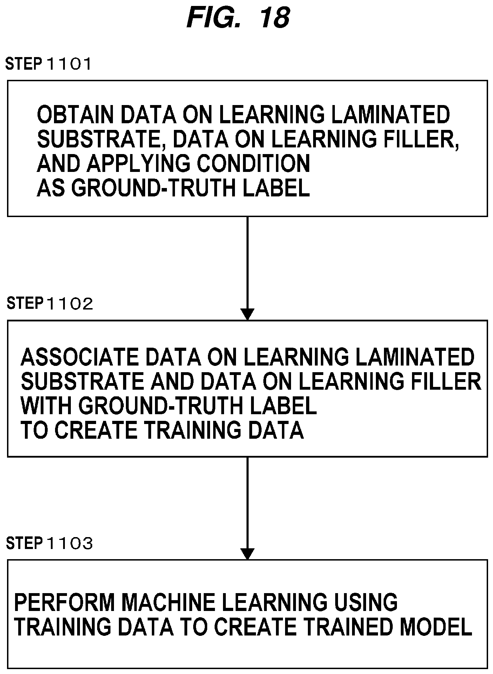

FIG. 18 is a flowchart illustrating an embodiment of a method of constructing the trained model by the machine learning.

In step 1101, the arithmetic system 110 obtains data on learning laminated substrates, data on learning fillers, and applying conditions as ground-truth labels via a not-shown input device, signal communication, or the like. The arithmetic system 110 stores these obtained data and the ground-truth labels into the memory 110a.

In step 1102, the arithmetic system 110 associates the data on the learning laminated substrates and the data on the learning fillers with the applying conditions which are the corresponding ground-truth labels to create training data.

In step 1103, the arithmetic system 110 performs the machine learning using the training data to construct (create) a trained model. The arithmetic system 110 stores the trained model into the memory 110a.

Next, the arithmetic system 110 determines an optimal applying condition for the laminated substrate Ws to which the filler F is to be applied with the trained model. More specifically, as shown in FIG. 17, the arithmetic system 110 inputs data on the laminated substrate Ws to which the filler F is to be applied (e.g., the shape and the size of the gap G in the edge portion, etc.), and data on the filler F to be applied to the laminated substrate Ws (e.g., the composition of the filler F) into the trained model, and performs arithmetic operations according to an algorithm defined by the trained model to thereby output the applying condition from the trained model. The arithmetic system 110 then instructs the filler application module 112 to apply the filler F to the gap G between the edge portion E1 of the first substrate W1 and the edge portion E2 and of the second substrate W2 constituting the laminated substrate Ws (see FIG. 12A) according to the applying condition output from the trained model.

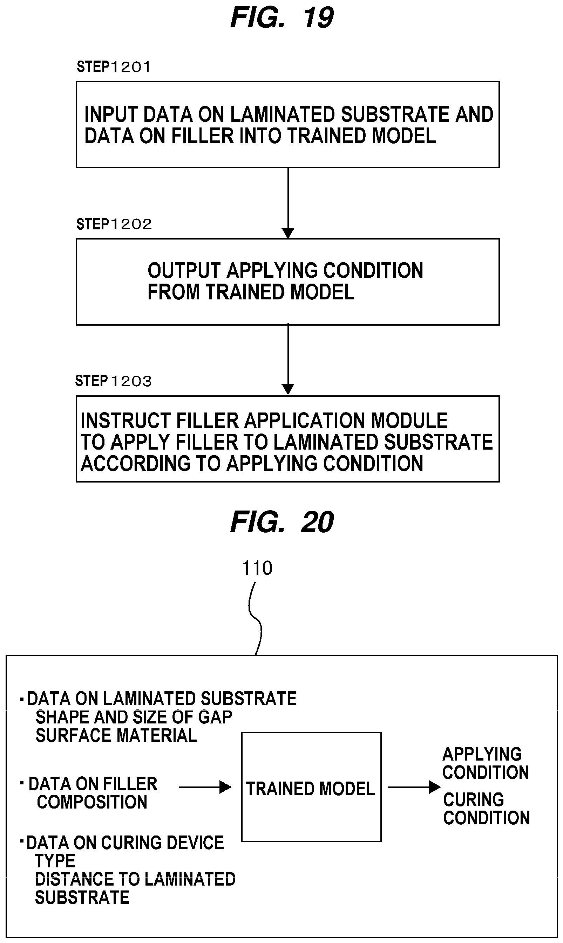

FIG. 19 is a flowchart illustrating an embodiment of a method of applying the filler F to the laminated substrate Ws according to the applying condition determined uising the trained model.

In step 1201, the arithmetic system 110 inputs data on the laminated substrate Ws to which the filler F is to be applied and data on the filler F to be applied to the laminated substrate Ws into the trained model.

In step 1202, the arithmetic system 110 outputs the applying condition from the trained model by performing the arithmetic operations according to the algorithm defined by the trained model.

In step 1203, the arithmetic system 110 instructs the filler application module 112 to apply the filler F to the gap G between the edge portion E1 of the first substrate W1 and the edge portion E2 of the second substrate W2 constituting the laminated substrate Ws. The filler application module 112 applies the filler F to the gap G in the edge portion of the laminated substrate Ws according to the applying condition determined in the step 1202. The filler F is then cured by the curing device 120 shown in FIGS. 14 and 15, and the laminated substrate Ws with the cured filler F is thinned by a not-shown thinning device.

According to this embodiment, an appropriate applying condition is determined by the trained model, and an appropriate amount of the filler F is applied to the laminated substrate Ws according to the applying condition. As a result, cracking or chipping of the knife-edge portion of the laminated substrate Ws can be prevented, and contamination of surrounding environment can be prevented.

Since the applying condition obtained in the step 1202 is expected to achieve a good application result, the applying condition can be used as a ground-truth label. Thus, in one embodiment, the arithmetic system 110 may update the training data by adding the data on the laminated substrate Ws and the data on the filler F which have been input to the trained model in the step 1201, and the applying condition as the ground-truth label which has been output from the trained model in the step 1202 to the training data. The arithmetic system 110 may perform the machine learning again using the updated training data to update the trained model. In this way, an accuracy of the trained model can be improved by updating the trained model.

Next, another embodiment of the substrate processing method and the substrate processing apparatus 105 will be described. Configurations and operations of this embodiment, which will be not particularly described, are the same as those of the embodiments described with reference to FIGS. 12A to 19, and duplicated descriptions will be omitted.

In this embodiment, as shown in FIG. 20, the arithmetic system 110 is configured to input data on the curing device 120 for curing the filler F (see FIGS. 14 and 15), in addition to the data on the laminated substrate Ws and the data on the filler F, into the trained model, and output an applying condition for the filler F and a curing condition for the filler F from the trained model.

The data on the curing device 120 include a type of the curing device 120 and a distance between the curing device 120 and the edge portion of the laminated substrate Ws. Examples of the type of the curing device 120 include a lamp heater, an air heater, and a UV irradiation device. The type of the curing device 120 is predetermined based on the material of the filler F.

The curing condition includes an output value of the curing device 120. The output value of the curing device 120 varies depending on the type of the curing device 120. For example, when the curing device 120 is a lamp heater, the output value of the curing device 120 is a lamp power [W], when the curing device 120 is an air heater, the output value of the curing device 120 is temperature of hot air or an output [W] of a heat source, and when the curing device 120 is a UV irradiation device, the output value of the curing device 120 is an illuminance of a UV source.

The arithmetic system 110 instructs the filler application module 112 to apply the filler F to the gap G between the edge portion E1 of the first substrate W1 and the edge portion E2 of the second substrate W2 constituting the laminated substrate Ws (see FIG. 12A) according to the applying condition output from the trained model. Further, the arithmetic system 110 instructs the filler application module 112 to cure the filler F by the curing device 120 according to the curing condition output from the trained model.

The training data for use in the machine learning to construct the trained model include data on training laminated substrates, data on training fillers, data on curing devices, and applying conditions and curing conditions as ground-truth labels.

The data on the curing devices in the training data include data on different curing devices. The data on the different curing devices include at least one of different types of curing devices and different distances between the curing devices and the edge portion of the laminated substrate.

The applying conditions and the curing conditions as the ground-truth labels are applying conditions and curing conditions when good application results for the filler have been obtained. More specifically, the applying conditions and the curing conditions as the ground-truth labels are applying conditions and curing conditions when the learning fillers have been actually applied to the learning laminated substrates, the applied learning fillers have been cured by the curing device, and good application results have been obtained. As discussed in the above-described embodiments, whether the applied state of the learning filler is good or not is determined by observing the edge portion of the learning laminated substrate to which the learning filler is actually applied.

The curing conditions as the ground-truth labels include output values of the curing devices. Each output value of each curing device varies depending on the type of the curing device. For example, when the curing device is a lamp heater, the output value of the curing device is a lamp power [W], when the curing device is an air heater, the output value of the curing device is temperature of hot air or an output [W] of a heat source, and when the curing device is a UV irradiation device, the output value of the curing device is an illuminance of a UV source.

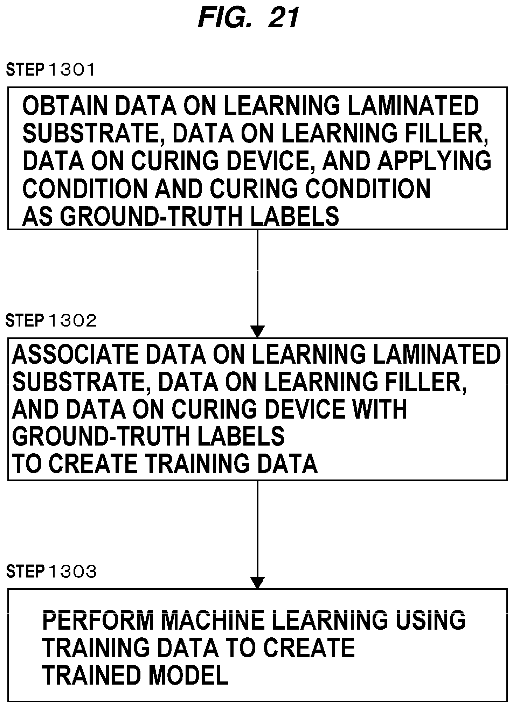

FIG. 21 is a flowchart illustrating an embodiment of a method of constructing the trained model using the machine learning.

In step 1301, the arithmetic system 110 obtains data on learning laminated substrates, data on learning fillers, data on curing devices, and applying conditions and curing conditions as ground-truth labels via a not-shown input device, signal communication, or the like. The arithmetic system 110 stores these obtained data and the ground-truth labels into the memory 110a.

In step 1302, the arithmetic system 110 associates the data on the learning laminated substrates, the data on the learning fillers, and the data on the curing devices with the applying conditions and the curing conditions which are the corresponding ground-truth labels to create training data.

In step 1303, the arithmetic system 110 performs the machine learning using the training data to construct (create) a trained model. The arithmetic system 110 stores the trained model into the memory 110a.

Next, the arithmetic system 110 determines an optimal applying condition for the laminated substrate Ws to which the filler F is to be applied, and an optimal curing condition for the filler F applied to the laminated substrate Ws with the trained model. More specifically, as shown in FIG. 20, the arithmetic system 110 inputs data on the laminated substrate Ws to which the filler F is to be applied (e.g., the shape and the size of the gap G in the edge portion, etc.), data on the filler F to be applied to the laminated substrate Ws (e.g., the composition of the filler F), and data on the curing device 120 (e.g., the type of the curing device 120) into the trained model, and performs arithmetic operations according to an algorithm defined by the trained model to thereby output the applying condition and the curing condition from the trained model. The arithmetic system 110 then instructs the filler application module 112 to apply the filler F to the gap G between the edge portion E1 of the first substrate W1 and the edge portion E2 of the second substrate W2 constituting the laminated substrate Ws (see FIG. 12A) according to the applying condition output from the trained model. Further, the arithmetic system 110 instructs the filler application module 112 to cure the filler F by the curing device 120 according to the curing condition output from the trained model.

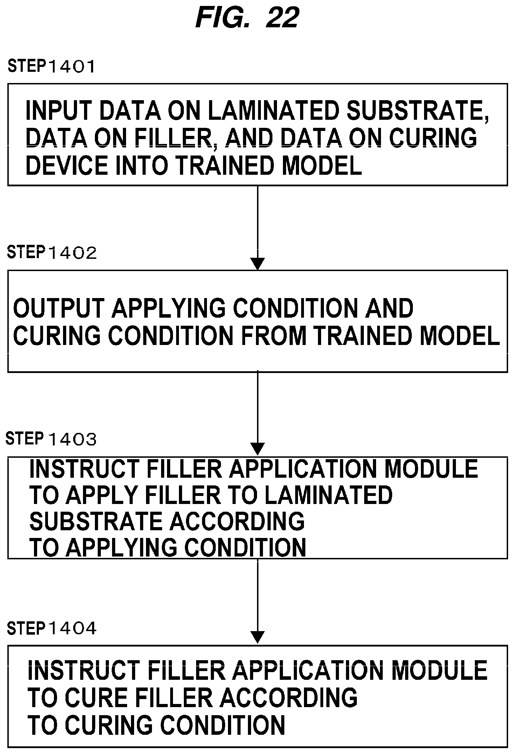

FIG. 22 is a flowchart illustrating an embodiment of a method of applying the filler F to the laminated substrate Ws and curing the filler F according to the applying condition and the curing condition determined using the trained model.

In step 1401, the arithmetic system 110 inputs the data on the laminated substrate Ws to which the filler F is to be applied, the data on the filler F to be applied to the laminated substrate Ws, and the data on the curing device 120 for curing the applied filler F into the trained model.

In step 1402, the arithmetic system 110 outputs the applying condition and the curing condition from the trained model by performing arithmetic operations according to the algorithm defined by the trained model.

In step 1403, the arithmetic system 110 instructs the filler application module 112 to apply the filler F to the gap G between the edge portion E1 of the first substrate W1 and the edge portion E2 of the second substrate W2 constituting the laminated substrate Ws. The filler application module 112 applies the filler F to the gap G in the edge portion of the laminated substrate Ws according to the applying condition determined in the step 1402.

In step 1404, the arithmetic system 110 instructs the filler application module 112 to cause the curing device 120 to cure the filler F filled in the gap G of the laminated substrate Ws. The curing device 120 of the filler application module 112 cures the filler F according to the curing condition determined in the step 1402. The step 1403 and the step 1404 may overlap in time. The laminated substrate Ws with the cured filler F is then thinned by a not-shown thinning device.

According to this embodiment, an appropriate amount of the filler F is applied to the laminated substrate Ws according to the applying condition, and the filler F is appropriately cured according to the curing condition. As a result, cracking or chipping of the knife-edge portion of the laminated substrate Ws can be prevented, and contamination of surrounding environment can be prevented.

Since the applying condition and the curing condition obtained in the step 1402 are expected to achieve a good application result, the applying condition and the curing condition can be used as ground-truth label. Thus, in one embodiment, the arithmetic system 110 may update the training data by adding the data on the laminated substrate Ws, the data on the filler F, and the data on the curing device 120 which have been input to the trained model in the step 1401, and the applying condition and the curing condition as the ground-truth label which have been output from the trained model in the step 1402 to the training data. The arithmetic system 110 may perform the machine learning again using the updated training data to update the trained model. In this way, an accuracy of the trained model can be improved by updating the trained model.

Next, another embodiment of the substrate processing method and the substrate processing apparatus 105 will be described. Configurations and operations of this embodiment, which will be not particularly described, are the same as those of the embodiment described with reference to FIGS. 20 to 22, and duplicated descriptions will be omitted.

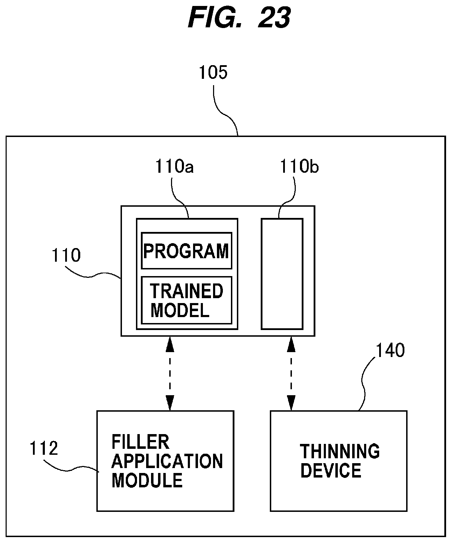

FIG. 23 is a schematic diagram showing another embodiment of the substrate processing apparatus 105. As shown in FIG. 23, the substrate processing apparatus 105 of this embodiment further includes a thinning device 140 configured to thin the laminated substrate Ws to which the filler F has been applied and has been cured by the filler application module 112. The arithmetic system 110 is configured to control operations of the filler application module 112 and the thinning device 140. The laminated substrate Ws is transported from the filler application module 112 to the thinning device 140 by a not-shown transporting device. The filler application module 112 and/or the thinning device 140 may be disposed in separated location from the arithmetic system 110.

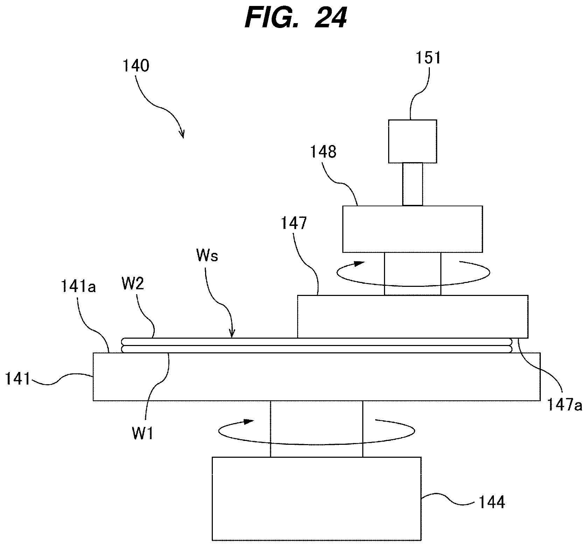

FIG. 24 is a schematic diagram showing an embodiment of the thinning device 140. The thinning device 140 includes a holding stage 141 configured to hold the laminated substrate Ws, a stage rotating device 144 configured to rotate the holding stage 141, a grinding tool 147 configured to grind the second substrate W2 that constitutes the laminated substrate Ws placed on the holding stage 141, a grinding-tool rotating device 148 configured to rotate the grinding tool 147, and a grinding-tool pressing device 151 configured to press the grinding tool 147 against the laminated substrate Ws placed on the holding stage 141. The grinding tool 147 has a grinding-surface 147a to which cutting particles, such as diamond particles, are fixed. The holding stage 141 is configured to be able to hold the laminated substrate Ws on its stage surface 141a by vacuum suction or the like.

The laminated substrate Ws is placed on the stage surface 141a of the holding stage 141 with the second substrate W2 facing the grinding-surface 147a of the grinding tool 147. The first substrate W1 of the laminated substrate Ws is held on the stage surface 141a of the holding stage 141 by vacuum suction or the like. When the stage rotating device 144 rotates the holding stage 141, the laminated substrate Ws placed on the holding stage 141 rotates. The grinding-tool pressing device 151 presses the grinding-surface 147a of the grinding tool 147 against the second substrate W2 of the laminated substrate Ws, while the grinding-tool rotating device 148 rotates the grinding tool 147. The second substrate W2 is ground by the grinding tool 147, so that the laminated substrate Ws is thinned (see FIG. 12C). A rotation speed of the grinding tool 147 is regulated by the grinding-tool rotating device 148, a pressing force of the grinding tool 147 against the laminated substrate Ws is regulated by the grinding-tool pressing device 151, and a rotation speed of the laminated substrate Ws is regulated by the stage rotating device 144.

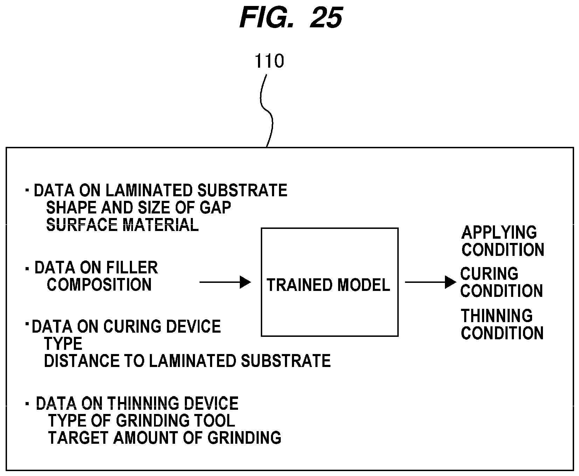

FIG. 25 is a conceptual diagram illustrating an operation of the arithmetic system 110 of this embodiment. As shown in FIG. 25, the arithmetic system 110 is configured to input data on the thinning device 140, in addition to the data on the laminated substrate Ws, the data on the filler F, and the data on the curing device 120, into the trained model, and output an applying condition for the filler F, a curing condition for the filler F, and a thinning condition for the laminated substrate Ws. Further, the arithmetic system 110 is configured to instruct the filler application module 112 to apply the filler F to the gap G between the edge portion E1 of the first substrate W1 and the edge portion of the second substrate W2 constituting the laminated substrate Ws (see FIG. 12A) according to the applying condition output from the trained model. Further, the arithmetic system 110 is configured to instruct the filler application module 112 to cause the curing device 120 to cure the filler F according to the curing condition output from the trained model. Furthermore, the arithmetic system 110 is configured to instruct the thinning device 140 to thin the laminated substrate Ws having the cured filler F according to the thinning condition output from the trained model.

The data on the thinning device 140 include a type of the grinding tool 147 for use in the thinning device 140, and a target amount of grinding of the laminated substrate Ws. The type of the grinding tool 147 is, for example, a roughness of the cutting particles constituting the grinding-surface 147a. The thinning condition is, in other words, an operating condition of the thinning device 140, and examples of the thinning condition include the rotation speed of the grinding tool 147, the pressing force of the grinding tool 147 against the laminated substrate Ws, and the rotation speed of the laminated substrate Ws (i.e., a rotation speed of the holding stage 141).

The training data for use in the machine learning to construct the trained model include data on learning laminated substrates, data on learning fillers, data on curing devices, and data on thinning devices, and further include applying conditions, curing conditions, and thinning conditions as ground-truth labels.

The data on the thinning devices in the training data include data on different thinning devices. The data on the different thinning devices include at least one of different types of grinding tools and different target amounts of grinding of the laminated substrate.

The applying conditions, the curing conditions, and the thinning conditions as the ground-truth labels are applying conditions, curing conditions, and thinning conditions when good application results and good thinning results have been obtained. More specifically, the applying conditions, the curing conditions, and the thinning conditions as the ground-truth labels are applying conditions, curing conditions, and thinning conditions when the learning fillers have been actually applied to the learning laminated substrates, the applied learning fillers have been cured by the curing device, the learning laminated substrates have been thinned by the thinning device, and good application results and good thinning results have been obtained.

As described in the above embodiments, whether the applied state of the learning filler is good or not is determined by observing the edge portion of the learning laminated substrate to which the learning filler is actually applied. A good thinning result is determined based on a fact that the laminated substrate is thinned without causing clogging of the grinding tool, and that a time from start of grinding to a time when the target amount of grinding is reached is less than or equal to an allowable time. Generally, clogging of the grinding tool is caused by the particles contained in the filler. The time from start of grinding to a time when the target amount of grinding is reached varies depending on a hardness of the cured filler, which in turn depends on the material of the filler. Therefore, the thinning condition as the ground-truth label is a thinning condition when the thinning is completed in a short time without causing clogging of the grinding tool.

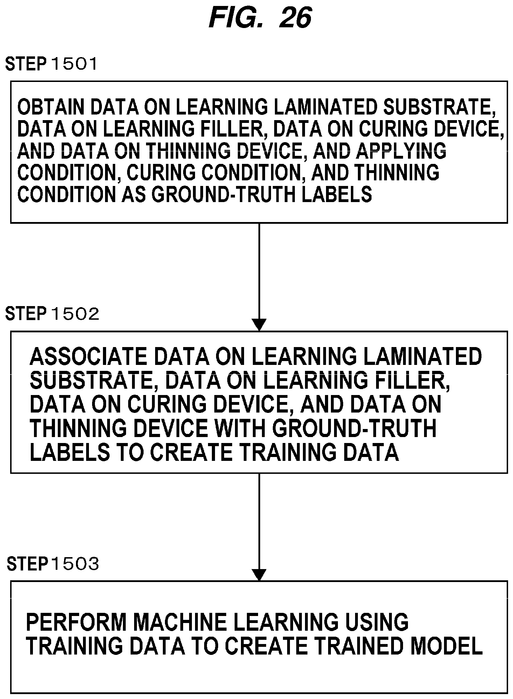

FIG. 26 is a flowchart illustrating an embodiment of a method of constructing the trained model with machine learning.

In step 1501, the arithmetic system 110 obtains data on learning laminated substrates, data on learning fillers, data on curing devices, and data on thinning devices, and further obtains applying conditions, curing conditions, and thinning conditions as ground-truth labels via a not-shown input device, signal communication, or the like. The arithmetic system 110 stores the obtained data and the ground-truth labels into the memory 110a.

In step 1502, the arithmetic system 110 associates the data on the learning laminated substrates, the data on the learning fillers, the data on the curing devices, and the data on the thinning devices with the applying conditions, the curing conditions, and the thinning conditions which are the corresponding ground-truth labels to create training data.

In step 1503, the arithmetic system 110 performs the machine learning using the training data to construct (create) a trained model. The arithmetic system 110 stores the trained model into the memory 110a.

Next, the arithmetic system 110 determines an optimal applying condition for the laminated substrate Ws to which the filler F is to be applied, an optimal curing condition for the filler F applied to the laminated substrate Ws, and an optimal thinning condition for the laminated substrate Ws with the cured filler F using the trained model. More specifically, as shown in FIG. 25, the arithmetic system 110 inputs data on the laminated substrate Ws to which the filler F is to be applied (e.g., the shape and the size of the gap G in the edge portion, etc.), data on the filler F to be applied to the laminated substrate Ws (e.g., the composition of the filler F), data on the curing device 120 (e.g., the type of the curing device 120), and data on the thinning device 140 (e.g., the type of the grinding tool) into the trained model, and performs arithmetic operations according to an algorithm defined by the trained model to thereby output the applying condition, the curing condition, and the thinning condition from the trained model.

Then, the arithmetic system 110 instructs the filler application module 112 to apply the filler F to the gap G between the edge portion E1 of the first substrate W1 and the edge portion of the second substrate W2 constituting the laminated substrate Ws (see FIG. 12A) according to the applying condition output from the trained model. Further, the arithmetic system 110 instructs the filler application module 112 to cause the curing device 120 to cure the filler F according to the curing condition output from the trained model. Furthermore, the arithmetic system 110 instructs the thinning device 140 to thin the laminated substrate Ws with the cured filler F according to the thinning condition output from the trained model.

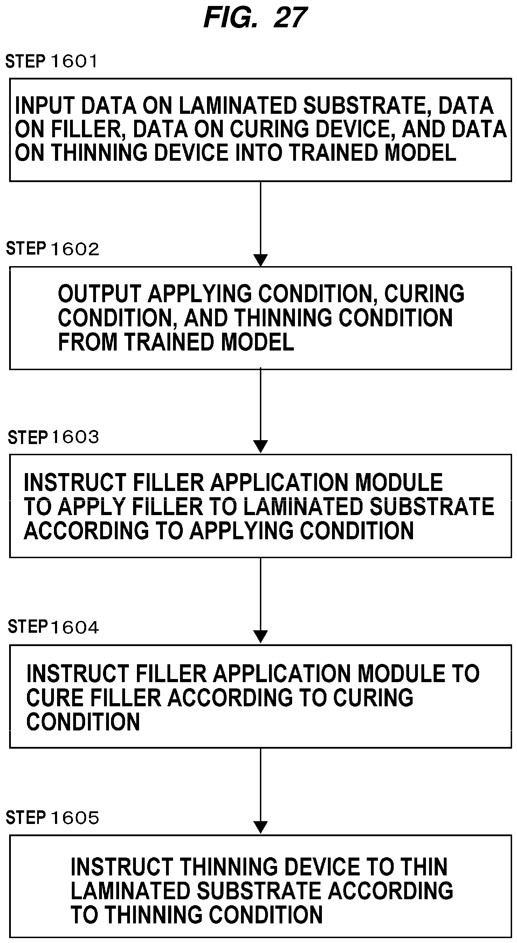

FIG. 27 is a flowchart illustrating an embodiment of a method of applying the filler F to the laminated substrate Ws, curing the filler F, and thinning the laminated substrate Ws according to the applying condition, the curing condition, and the thinning condition determined using the trained model.

In step 1601, the arithmetic system 110 inputs the data on the laminated substrate Ws to which the filler F is to be applied, the data on the filler F to be applied to the laminated substrate Ws, the data on the curing device 120 for curing the applied filler F, the data on the thinning device 140 for thinning the laminated substrate Ws with the cured filler F into the trained model.

In step 1602, the arithmetic system 110 outputs the applying condition, the curing condition, and the thinning condition from the trained model by performing arithmetic operations according to the algorithm defined by the trained model.

In step 1603, the arithmetic system 110 instructs the filler application module 112 to apply the filler F to the gap G between the edge portion E1 of the first substrate W1 and the edge portion E2 of the second substrate W2 constituting the laminated substrate Ws. The filler application module 112 applies the filler F to the gap G in the edge portion of the laminated substrate Ws according to the applying condition determined in the step 1602.

In step 1604, the arithmetic system 110 instructs the filler application module 112 to cause the curing device 120 to cure the filler F filling the gap G of the laminated substrate Ws. The curing device 120 of the filler application module 112 cures the filler F according to the curing condition determined in the step 1602. The step 1603 and the step 1604 may overlap in time.

In step 1605, the arithmetic system 110 instructs the thinning device 140 to thin the laminated substrate Ws according to the thinning condition output from the trained model. The thinning device 140 thins the laminated substrate Ws having the cured filler F according to the thinning condition determined in the step 1602.

According to this embodiment, an appropriate amount of the filler F is applied to the laminated substrate Ws according to the applying condition, the filler F is appropriately cured according to the curing condition, and the laminated substrate Ws is appropriately thinned according to the thinning condition. As a result, cracking or chipping of the knife-edge portion of the laminated substrate Ws can be prevented, and contamination of surrounding environment can be prevented. In addition, the thinning condition is optimized, so that clogging of the grinding tool can be prevented, and a throughput of the thinning process can be improved.

The applying condition, the curing condition, and the thinning condition obtained in the step 1602 are expected to achieve a good application result and a good thinning result. Therefore, the applying condition, the curing condition, and the thinning condition can be used as ground-truth label. Thus, in one embodiment, the arithmetic system 110 may update the training data by adding the data on the laminated substrate Ws, the data on the filler F, the data on the curing device 120, and the data on the thinning device 140 which have been input to the trained model in the step 1601, and the applying condition, the curing condition, and the thinning condition as the ground-truth labels which have been output from the trained model in the step 1602 to the training data. The arithmetic system 110 may perform the machine learning again with the updated training data to update the trained model. In this way, an accuracy of the trained model can be improved by updating the trained model.

Next, another embodiment of the substrate processing method will be described. Configurations and operations of this embodiment, which will not be particularly described, are the same as those of the embodiment described with reference to FIGS. 23 to 27, and duplicated descriptions will be omitted.

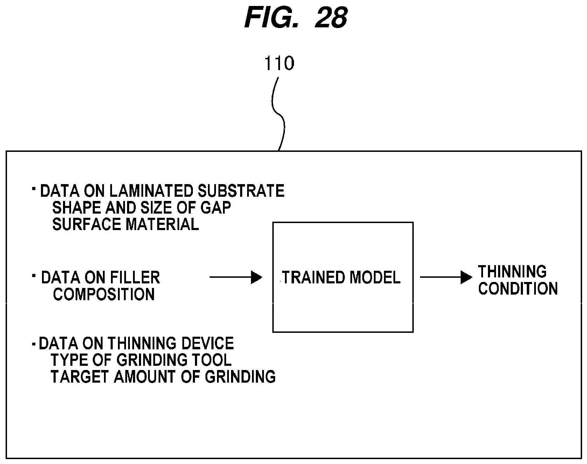

In this embodiment, the trained model is configured to calculate a thinning condition for thinning the laminated substrate Ws with the filler F that has already been applied and cured. FIG. 28 is a conceptual diagram illustrating an operation of the arithmetic system 110 of this embodiment. As shown in FIG. 28, the arithmetic system 110 is configured to input data on the laminated substrate Ws, data on the filler F, and data on the thinning device 140 into the trained model, and output the thinning condition for the laminated substrate Ws from the trained model. Further, the arithmetic system 110 is configured to instruct the thinning device 140 to thin the laminated substrate Ws having the cured filler F according to the thinning condition output from the trained model.

The training data for use in the machine learning to construct the trained model include data on training laminated substrates, data on training fillers, data on thinning devices, and thinning conditions as ground-truth labels. The data on the thinning devices in the training data include data on different thinning devices. The data on the different thinning devices include at least one of different types of grinding tools and different target amounts of grinding of the laminated substrate.

The thinning conditions as the ground-truth labels are thinning conditions when good thinning results have been obtained. More specifically, the thinning conditions as the ground-truth labels are thinning conditions when the laminated substrates each having the cured filler in the gap in the edge portion have been thinned by the thinning device, and good thinning results have been obtained. The thinning condition when a good thinning result has been obtained is a thinning condition when the thinning is completed in a short time without causing clogging of the grinding tool.

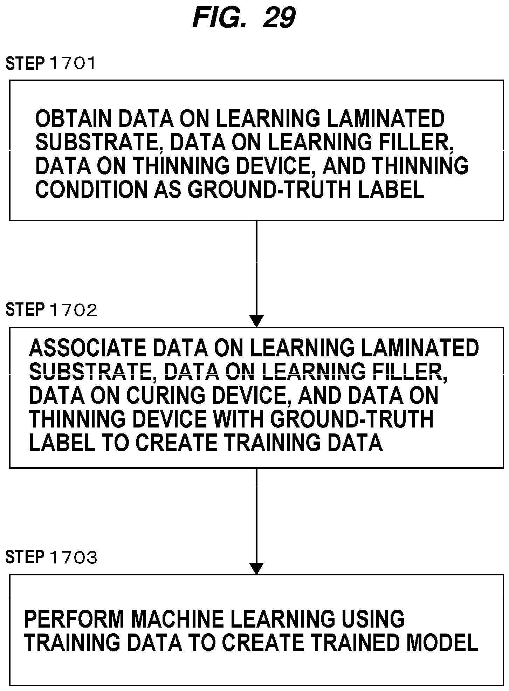

FIG. 29 is a flowchart illustrating an embodiment of a method of constructing the trained model with machine learning.

In step 1701, the arithmetic system 110 obtains data on learning laminated substrates, data on learning fillers, data on thinning devices, and thinning conditions as ground-truth labels via a not-shown input device, signal communication, or the like. The arithmetic system 110 stores the obtained data and the ground-truth labels into the memory 110a.

In step 1702, the arithmetic system 110 associates the data on the learning laminated substrates, the data on the learning fillers, and the data on the thinning devices with the thinning conditions which are the corresponding ground-truth labels to create training data.

In step 1703, the arithmetic system 110 performs the machine learning using the training data to construct (create) a trained model. The arithmetic system 110 stores the trained model into the memory 110a.

Next, the arithmetic system 110 determines an optimal thinning condition for thinning the laminated substrate Ws with the cured filler F using the trained model. More specifically, as shown in FIG. 28, the arithmetic system 110 inputs data on the laminated substrate Ws with the applied filler F (e.g., the shape and the size of the gap G in the edge portion, etc.), data on the filler F applied to the laminated substrate Ws (e.g., the composition of the filler F), and data on the thinning device 140 (e.g., the type of the grinding tool 147) into the trained model, and performs arithmetic operations according to an algorithm defined by the trained model thereby to output the thinning condition from the trained model. Then, the arithmetic system 110 instructs the thinning device 140 to thin the laminated substrate Ws with the cured filler F according to the thinning condition output from the trained model.

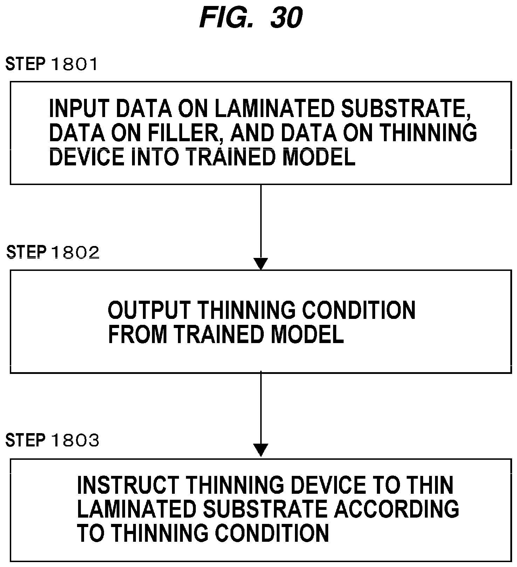

FIG. 30 is a flowchart illustrating an embodiment of a method of thinning the laminated substrate Ws with the cured filler F according to the thinning condition determined using the trained model.

In step 1801, the arithmetic system 110 inputs the data on the laminated substrate Ws with the applied filler F, the data on the filler F applied to the laminated substrate Ws, and the data on the thinning device 140 for thinning the laminated substrate Ws with the cured filler F into the trained model.

In step 1802, the arithmetic system 110 outputs the thinning condition from the trained model by performing arithmetic operations according to the algorithm defined by the trained model.

In step 1803, the arithmetic system 110 instructs the thinning device 140 to thin the laminated substrate Ws according to the thinning condition output from the trained model.

According to this embodiment, the thinning condition is optimized, so that clogging of the grinding tool can be prevented, and a throughput of the thinning process can be improved.

Since the thinning condition obtained in the step 1802 is expected to achieve a good thinning result, the thinning condition can be used as a ground-truth label. Thus, in one embodiment, the arithmetic system 110 may update the training data by adding the data on the laminated substrate Ws, the data on the filler F, and the data on the thinning device 140 which have been input to the trained model in the step 1801, and the thinning condition as the ground-truth label which has been output from the trained model in the step 1802 to the training data. The arithmetic system 110 may perform the machine learning again with the updated training data to update the trained model. In this way, an accuracy of the trained model can be improved by updating the trained model.

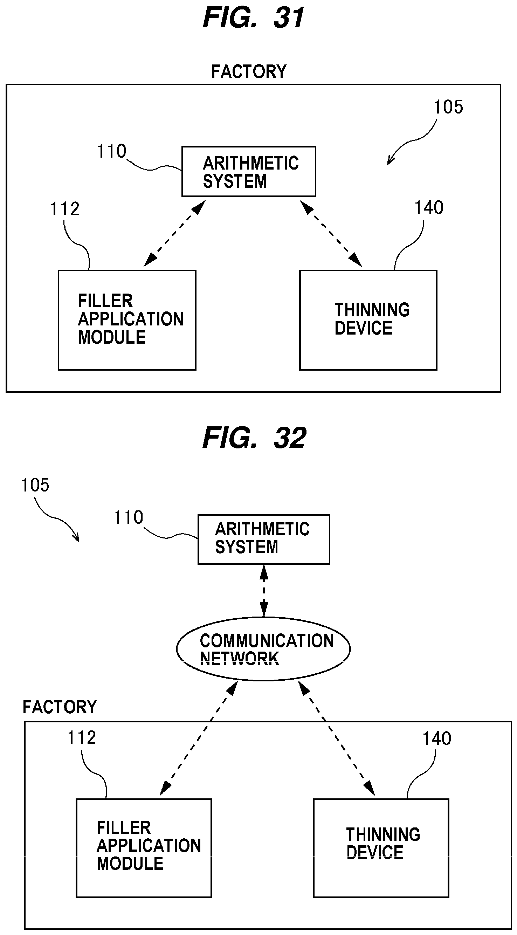

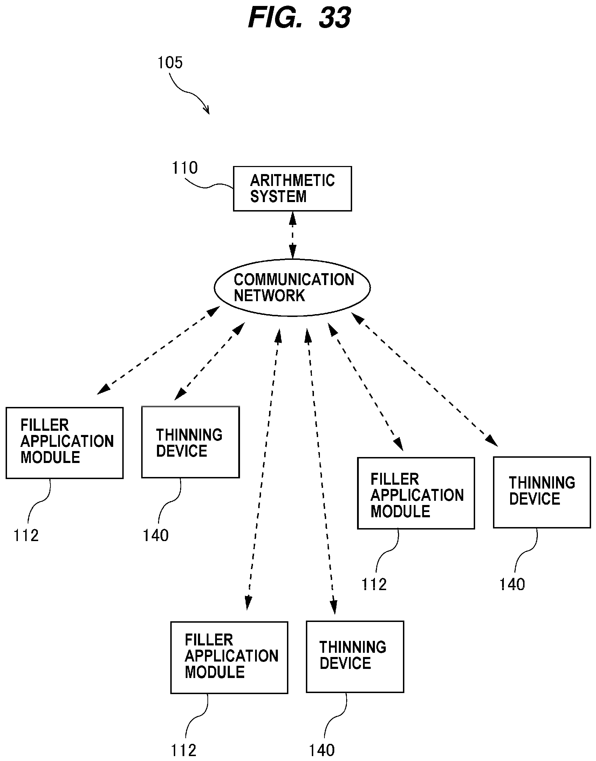

The arrangements of the elements constituting the substrate processing apparatus 105 according to each of the embodiments described with reference to FIGS. 14 to 30 are not particularly limited. For example, as shown in FIG. 31, the arithmetic system 110, the filler application module 112, and the thinning device 140 may be disposed in one factory. Alternatively, as shown in FIG. 32, the filler application module 112 and the thinning device 140 may be disposed in one factory, while the arithmetic system 110 may be disposed outside the factory. The arithmetic system 110 is coupled to the filler application module 112 and the thinning device 140 by a communication network, such as the Internet. In another example, as shown in FIG. 33, the arithmetic system 110 may be coupled to filler application modules 112 and thinning devices 140 at remote locations by a communication network, such as the Internet.

The operations of the substrate processing apparatus 105 in each of the embodiments described above are controlled by the arithmetic system 110. The arithmetic system 110 is composed of at least one computer. The arithmetic system 110 operates according to the instructions contained in the programs electrically stored in the memory 110a. Specifically, the arithmetic system 110 instructs the filler application module 112 and/or the thinning device 140 to perform the substrate processing method of any of the embodiments described above. The programs for causing the arithmetic system 110 to perform such operations are stored in a non-transitory tangible computer-readable storage medium, and are provided to the arithmetic system 110 via the storage medium. Alternatively, the programs may be input into the arithmetic system 110 from a communication device via a communication network, such as the Internet or a local area network.

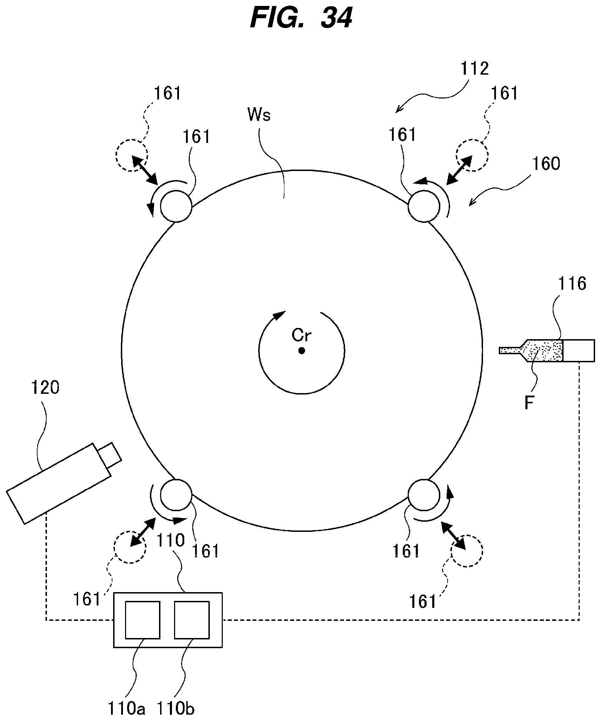

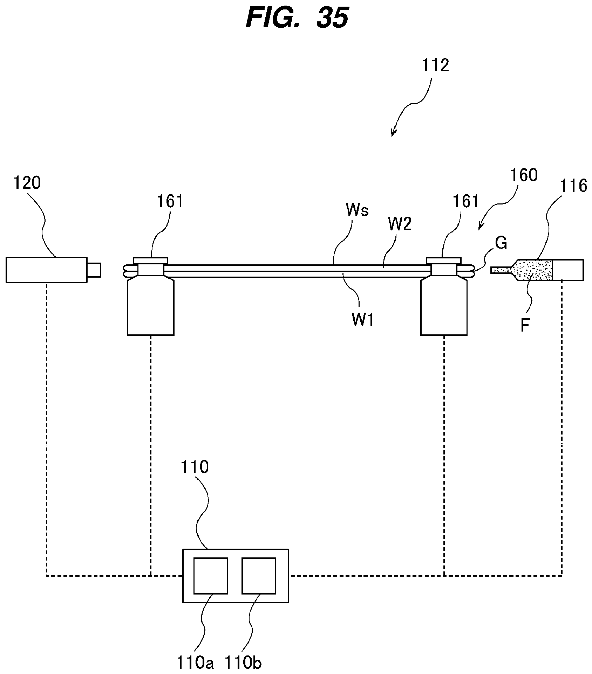

FIG. 34 is a plan view showing another embodiment of the filler application module 112. FIG. 35 is a side view of the filler application module 112 shown in FIG. 34. Configurations of this embodiment, which will not be particularly described, are the same as the configurations of the embodiment described with reference to FIG. 14 and FIG. 15, and duplicated descriptions will be omitted. In this embodiment, the filler application module 112 includes a substrate holding device 160 instead of the substrate holder 115, the rotating shaft 122, and the rotating mechanism 123.

The substrate holding device 160 includes three or more (in this embodiment, four) rollers 161 which can contact a periphery of the laminated substrate Ws, a roller rotating mechanism (not shown) configured to rotate the rollers 161 about their respective own axes, and a roller moving mechanism (not shown) configured to move the rollers 161. In this embodiment, the substrate holding device 160 includes the four rollers 161, while the substrate holding device 160 may include three, or five or more rollers.

The four rollers 161 are arranged around a central axis Cr of the laminated substrate Ws. Each of the rollers 161 is configured to contact the periphery of the laminated substrate Ws to hold the laminated substrate Ws horizontally. The configuration of the roller rotating mechanism is not limited as long as three or more rollers 161 can be rotated in the same direction at the same speed, and any known rotating mechanism can be used as the roller rotating mechanism. An example of the roller rotating mechanism is a combination of a motor, a pulley (and/or gears), and a rotating belt.

The roller rotating mechanism is coupled to the four rollers 161, and is configured to rotate the four rollers 161 in the same direction and at the same speed. The roller moving mechanism moves the four rollers 161 between a holding position where the periphery of the laminated substrate Ws is held by the rollers 161 (see a solid line in FIG. 34) and a releasing position where the laminated substrate Ws is released from the rollers 161 (see a dotted line in FIG. 34).

The configuration of the roller moving mechanism is not limited as long as the four rollers 161 can be moved between the holding position and the releasing position, and any known moving mechanism can be used as the roller moving mechanism. Examples of the roller moving mechanism include a piston cylinder mechanism, and a combination of a ball screw and a motor (e.g., a stepping motor).

The laminated substrate Ws is transported by a not-shown transporting device to a position where the axis of the laminated substrate Ws is aligned with the central axis Cr of the laminated substrate Ws. At this time, the rollers 161 are located in the releasing position. Next, the four rollers 161 are moved to the holding position by the roller moving mechanism, so that the periphery of the laminated substrate Ws is held by the four rollers 161. With this operation, the laminated substrate Ws is held in a horizontal posture by the four rollers 161. The four rollers 161 that have been moved to the holding position are rotated by the roller rotating mechanism, so that the laminated substrate Ws is rotated about its own axis.

When the four rollers 161 are moved from the holding position to the releasing position by the roller moving mechanism, the four rollers 161 are separated from the periphery of the laminated substrate Ws, so that the laminated substrate Ws can be released from the four rollers 161. The released laminated substrate Ws is transported for next processing by a not-shown transporting device. Application of the filler F by the application device 116 and curing of the filler F by the curing device 120 are performed while the laminated substrate Ws held in the horizontal posture is rotated by the substrate holding device 160. A rotation speed of the laminated substrate Ws depends on a rotation speed of the rollers 161 of the substrate holding device 160 and can be controlled by the roller rotating mechanism.

In one embodiment, the roller rotating mechanism may be configured to rotate only some of the rollers 161. For example, the roller rotating mechanism may be coupled to two of the four rollers 161 and may be configured to rotate the two rollers 161 in the same direction at the same speed. In this case, the other two rollers 161 are configured to rotate freely. When the four rollers 161 are located in the holding position, the two rollers 161 coupled to the roller rotating mechanism are rotated to cause the other two rollers 161 to rotate via the laminated substrate Ws.

In one embodiment, the roller moving mechanism may be configured to move only some of the rollers 161. For example, the roller moving mechanism may be coupled to two of the four rollers 161 and may be configured to move the two rollers 161 between the holding position and the releasing position. In this case, the other two rollers 161 are fixed in advance at the holding position. The laminated substrate Ws is transported by the transporting device to a position where the periphery of the laminated substrate Ws contacts the two rollers 161 fixed in position. The laminated substrate Ws can be held in the horizontal posture when the two rollers 161 coupled to the roller moving mechanism are moved to the holding position by the roller moving mechanism. The laminated substrate Ws can be released when the two rollers 161 coupled to the roller moving mechanism are moved to the releasing position by the roller moving mechanism.

In the embodiments described above, the substrate holder 115 and the rollers 161 of the substrate holding device 160 are configured to hold the laminated substrate Ws horizontally. In other words, the laminated substrate Ws is held in the horizontal posture by the substrate holder 115 or the rollers 161 of the substrate holding device 160. Application of the filler F by the application device 116 is performed while the laminated substrate Ws is rotated horizontally by the substrate holder 115 or the rollers 161 of the substrate holding device 160. However, the holding method for the laminated substrate Ws is not limited to the above embodiments as long as the filler F can be applied to the gap G. For example, the filler application module 112 may include a substrate holder or a substrate holding device configured to hold the laminated substrate Ws vertically. When the laminated substrate Ws is held in a vertical posture, an upper surface and a lower surface of the laminated substrate Ws are each in an imaginary plane extending in a vertical direction perpendicular to a horizontal direction.

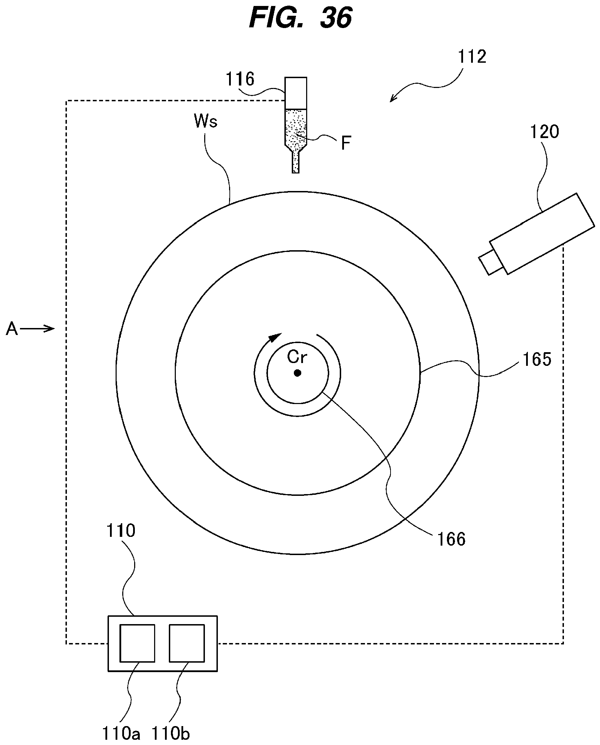

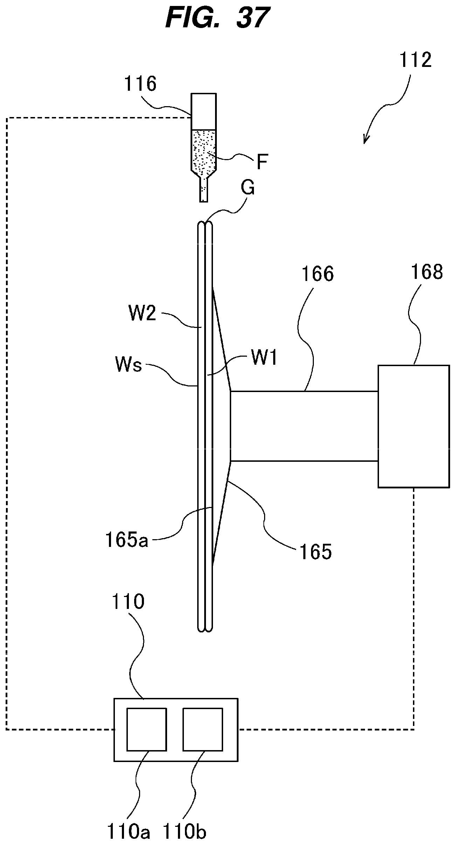

FIG. 36 is a side view showing still another embodiment of the filler application module 112. FIG. 37 is a diagram as viewed from a direction indicated by an arrow A in FIG. 36. Configurations of this embodiment, which will not be particularly described, are the same as the configurations of the embodiment described with reference to FIG. 14 and FIG. 15, and duplicated descriptions will be omitted. FIG. 36 is a diagram as viewed from a back side of the laminated substrate Ws. In this embodiment, the filler application module 112 includes a substrate holder 165, a rotating shaft 166, and a rotating mechanism 168 instead of the substrate holder 115, the rotating shaft 122, and the rotating mechanism 123.

The substrate holder 165 is configured to hold a back surface of the laminated substrate Ws by vacuum suction. As shown in FIG. 37, a holding surface 165a of the substrate holder 165 that holds the back surface of the laminated substrate Ws is perpendicular to a horizontal plane. The laminated substrate Ws is held perpendicularly to the horizontal plane. In other words, the laminated substrate Ws is held in a vertical posture by the substrate holder 165.

The rotating shaft 166 is coupled to a central portion of the substrate holder 165. The laminated substrate Ws is held by the substrate holder 165 such that the center of the laminated substrate Ws is aligned with a central axis of the rotating shaft 166. The rotating mechanism 168 includes a motor (not shown). As shown in FIG. 36, the rotating mechanism 168 is configured to rotate the substrate holder 165 and the laminated substrate Ws together in a direction shown by an arrow about a central axis Cr of the laminated substrate Ws.

The application device 116 is arranged above the laminated substrate Ws held by the substrate holder 165 and is arranged so as to face the gap G of the laminated substrate Ws. When the application device 116 emits the filler F, the filler F drops toward the gap G of the laminated substrate Ws, and as a result, the filler F can be applied to the gap G of the laminated substrate Ws. The curing device 120 is located radially outwardly of the laminated substrate Ws held by the substrate holder 165. The curing device 120 is disposed downstream of the application device 116 in a rotating direction of the laminated substrate Ws, and is configured to cure the filler F applied to the laminated substrate Ws by the application device 116. Application of the filler F by the application device 116 and curing of the filler F by the curing device 120 are performed while the laminated substrate Ws held in the vertical posture by the substrate holder 165 is rotated. A rotation speed of the laminated substrate Ws corresponds to a rotation speed of the substrate holder 165 and can be controlled by the rotating mechanism 168.

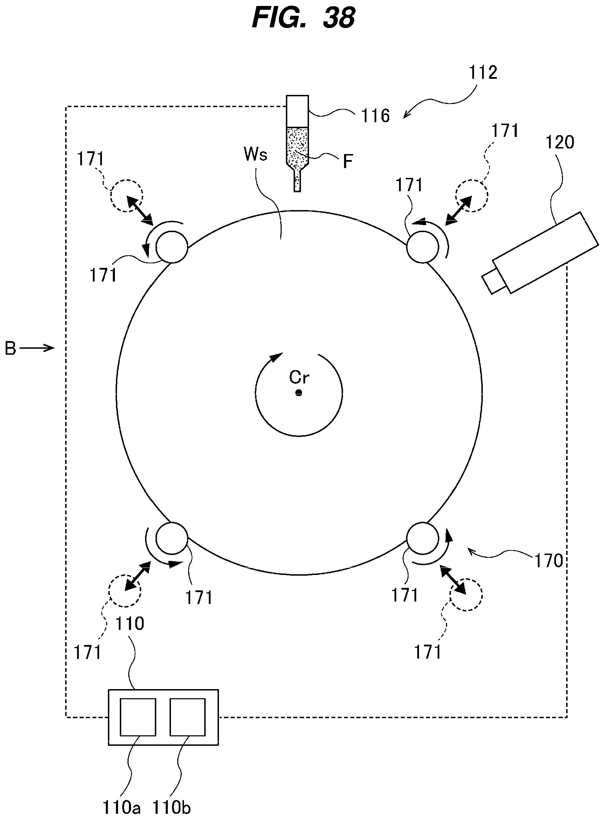

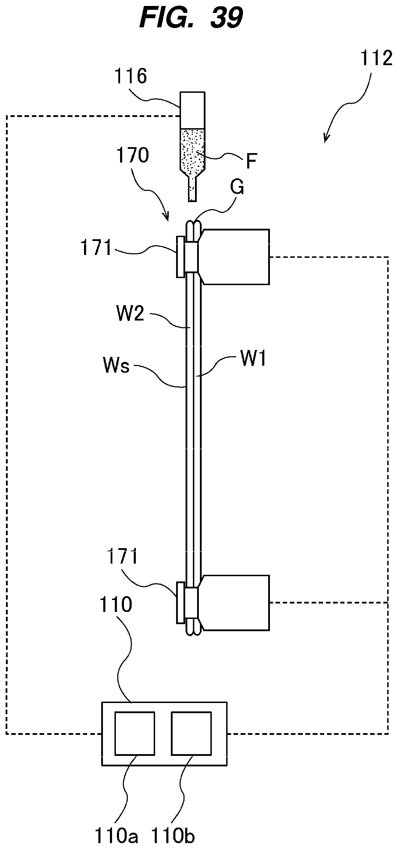

FIG. 38 is a side view showing still another embodiment of the filler application module 112. FIG. 39 is a diagram as viewed from a direction indicated by an arrow B in FIG. 38. Configurations of this embodiment, which will not be particularly described, are the same as the configurations of the embodiment described with reference to FIG. 36 and FIG. 37, and duplicated descriptions will be omitted. In this embodiment, the filler application module 112 includes a substrate holding device 170, instead of the substrate holder 165, the rotating shaft 166, and the rotating mechanism 168.

The substrate holding device 170 includes three or more (in this embodiment, four) rollers 171 which can contact the periphery of the laminated substrate Ws, a roller rotating mechanism (not shown) configured to rotate the rollers 171 about their respective own axes, and a roller moving mechanism (not shown) configured to move the rollers 171. In this embodiment, the substrate holding device 170 includes the four rollers 171, while the substrate holding device 170 may include three, or five or more rollers.

The four rollers 171 are arranged around the central axis Cr of the laminated substrate Ws. Each of the rollers 171 is configured to contact the periphery of the laminated substrate Ws to hold the laminated substrate Ws vertically. In other words, the laminated substrate Ws is held in a vertical posture by the rollers 171 of the substrate holding device 170. As shown in FIG. 38, when the laminated substrate Ws is held in the vertical posture by the rollers 171 of the substrate holding device 170, an upper surface and a lower surface of the laminated substrate Ws are each in an imaginary plane extending in a vertical direction.

The roller rotating mechanism is coupled to the four rollers 171, and is configured to rotate the four rollers 171 in the same direction at the same speed. The configuration of the roller rotating mechanism is not limited as long as three or more rollers 171 can be rotated in the same direction at the same speed, and any known rotating mechanism can be used as the roller rotating mechanism. An example of the roller rotating mechanism is a combination of a motor, a pulley (and/or gears), and a rotating belt.

The roller moving mechanism is coupled to the four rollers 171, and is configured to move each of the rollers 171 toward and away from the central axis Cr of the laminated substrate Ws. The roller moving mechanism moves the four rollers 171 between a holding position where the periphery of the laminated substrate Ws is held by the rollers 171 (see a solid line in FIG. 38) and a releasing position where the laminated substrate Ws is released from the rollers 161 (see a dotted line in FIG. 38). The configuration of the roller moving mechanism is not limited as long as the four rollers 171 can be moved between the holding position and the releasing position, and any known moving mechanism can be used as the roller moving mechanism. Examples of the roller moving mechanism include a piston cylinder mechanism, and a combination of a ball screw and a motor (e.g., a stepping motor).

The laminated substrate Ws is transported by a not-shown transporting device to a position where the axis of the laminated substrate Ws is aligned with the central axis Cr of the laminated substrate Ws. At this time, the rollers 171 are located in the releasing position. Next, the four rollers 171 are moved to the holding position by the roller moving mechanism, so that the periphery of the laminated substrate Ws is held by the four rollers 171. With this operation, the laminated substrate Ws is held in a vertical posture by the four rollers 171. The four rollers 171 that have been moved to the holding position are rotated by the roller rotating mechanism, so that the laminated substrate Ws is rotated about its own axis.

When the four rollers 171 are moved from the holding position to the releasing position by the roller moving mechanism, the four rollers 171 are separated from the periphery of the laminated substrate Ws, so that the laminated substrate Ws can be released from the four rollers 171. The released laminated substrate Ws is transported for next processing by a not-shown transporting device. Application of the filler F by the application device 116 and curing of the filler F by the curing device 120 are performed while the laminated substrate Ws held in the vertical posture is rotated by the substrate holding device 170. A rotation speed of the laminated substrate Ws depends on a rotation speed of the rollers 171 of the substrate holding device 170 and can be controlled by the roller rotating mechanism.

In one embodiment, the roller rotating mechanism may be configured to rotate only some of the rollers 171. For example, the roller rotating mechanism may be coupled to two of the four rollers 171 and may be configured to rotate the two rollers in the same direction and at the same speed. In this case, the other two rollers 171 are configured to rotate freely. When the four rollers 171 are located in the holding position, the two rollers 171 coupled to the roller rotating mechanism rotate to cause the other two rollers 171 to rotate following the two rollers 171 coupled to the roller rotating mechanism via the laminated substrate Ws.

In one embodiment, the roller moving mechanism may be configured to move only some of the rollers 171. For example, the roller moving mechanism may be coupled to two of the four rollers 171 and may be configured to move the two rollers 171 between the holding position and the releasing position. In this case, the other two rollers 171 are fixed in advance at the holding position. The laminated substrate Ws is transported by the transporting device to a position where the periphery of the laminated substrate Ws contacts the two rollers 171 fixed in position. The laminated substrate Ws can be held in the vertical posture when the two rollers 171 coupled to the roller moving mechanism are moved to the holding position by the roller moving mechanism. The laminated substrate Ws can be released when the two rollers 171 coupled to the roller moving mechanism are moved to the releasing position by the roller moving mechanism.

Each of the embodiments described with reference to FIGS. 34 to 39 may be applied to each of the embodiments described with reference to FIGS. 20 to 22, FIGS. 23 to 27, and FIGS. 28 to 30.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention is applicable to a substrate processing method and a substrate processing apparatus for suppressing cracking and chipping of a laminated substrate manufactured by bonding substrates, and more particularly to a technique of applying a filler to a gap formed between edge portions of the substrates constituting the laminated substrate.

### Reference Signs List

- 1: substrate processing apparatus
- 2: substrate holder
- 3: application device
- 4: curing device
- 5: infrared imaging device
- 7: rotating shaft
- 8: rotating mechanism
- 9: filler application module
- 10: operation controller
- 10a: memory
- 10b: processor
- 11: surface-shape measuring device
- 21: syringe
- 21a: filler emitting port
- 22: piston
- 25: gas supply line
- 26: pressure regulator
- 27: on-off valve
- 102: knife edge portion
- 105: substrate processing apparatus
- 110: arithmetic system
- 112: filler application module
- 115: substrate holder
- 116: application device
- 120: curing device
- 122: rotating shaft
- 123: rotating mechanism
- 126: syringe
- 126a: filler emitting port
- 127: piston
- 128: gas supply line
- 129: pressure regulator
- 140: thinning device
- 141: holding stage
- 144: stage rotating device
- 147: grinding tool
- 148: grinding-tool rotating device
- 151: grinding-tool pressing device
- 160: substrate holding device
- 161: roller
- 165: substrate holder
- 166: rotating shaft
- 168: rotating mechanism
- 170: substrate holding device
- 171: roller
- Ws: laminated substrate
- F: filler
- G: gap

## Claims

1. A substrate processing method of applying a filler to a laminated substrate having a first substrate and a second substrate bonded to each other, comprising:
measuring surface shapes of an edge portion of the first substrate and an edge portion of the second substrate;
determining an applying condition for the filler to be applied to the laminated substrate based on results of measuring of the surface shapes; and
applying the filler to a gap between the edge portion of the first substrate and the edge portion of the second substrate of the laminated substrate under the determined applying condition.

2. The substrate processing method according to claim 1, wherein measuring of the surface shapes of the edge portion of the first substrate and the edge portion of the second substrate is performed after the first substrate and the second substrate have been bonded.

3. The substrate processing method according to claim 1, wherein measuring of the surface shapes of the edge portion of the first substrate and the edge portion of the second substrate is performed before the first substrate and the second substrate are bonded.

4. The substrate processing method according to any one of claims 1 to 3, wherein the surface shapes of the edge portion of the first substrate and the edge portion of the second substrate to be measured are specified by at least one of:
(i) a dimension of the edge portion of the first substrate in a radial direction of the first substrate and a dimension of the edge portion of the second substrate in a radial direction of the second substrate;
(ii) a dimension of the gap in a thickness direction of the gap between the edge portion of the first substrate and the edge portion of the second substrate; and
(iii) an inclination angle of the edge portion of the first substrate and an inclination angle of the edge portion of the second substrate.

5. The substrate processing method according to any one of claims 1 to 4, wherein the applying condition includes at least one of a composition of the filler, a total amount of the filler to be applied, a shape of a filler emitting port of an application device configured to apply the filler, a distance between the laminated substrate and the filler emitting port, and an amount of the filler to be emitted from the filler emitting port per unit time.

6. The substrate processing method according to claim 5, further comprising curing the filler after applying the filler to the laminated substrate,
wherein the applying condition further includes wind pressure and temperature of hot air to be emitted from a curing device configured to cure the filler.

7. The substrate processing method according to claim 5 or 6, wherein applying of the filler is performed while rotating the laminated substrate, and
the applying condition further includes a rotation speed of the laminated substrate.

8. A substrate processing apparatus for applying a filler to a laminated substrate having a first substrate and a second substrate bonded to each other, comprising:
a filler application module configured to apply the filler to the laminated substrate;
a surface-shape measuring device configured to measure surface shapes of an edge portion of the first substrate and an edge portion of the second substrate; and
an operation controller configured to control operations of the filler application module and the surface-shape measuring device,
wherein the filler application module includes:
a substrate holder configured to hold the laminated substrate; and
an application device configured to apply the filler to a gap between the edge portion of the first substrate and the edge portion of the second substrate, and
the operation controller is configured to determine an applying condition for the filler to be applied to the laminated substrate based on measuring results of the shapes, and instruct the filler application module to apply the filler under the determined applying condition.

9. The substrate processing apparatus according to claim 8, wherein the surface-shape measuring device is configured to measure at least one of:
(i) a dimension of the edge portion of the first substrate in a radial direction of the first substrate and a dimension of the edge portion of the second substrate in a radial direction of the second substrate;
(ii) a dimension of the gap in a thickness direction of the gap between the edge portion of the first substrate and the edge portion of the second substrate; and
(iii) an inclination angle of the edge portion of the first substrate and an inclination angle of the edge portion of the second substrate.

10. The substrate processing apparatus according to claim 8 or 9, wherein the filler application module further includes a curing device configured to cure the filler.

11. The substrate processing method according to any one of claims 8 to 10, wherein the filler application module further includes a rotating mechanism configured to rotate the substrate holder.

12. A substrate processing method comprising:
inputting data on a laminated substrate having a first substrate and a second substrate bonded to each other, and data on a filler into a trained model constructed by machine learning;
outputting an applying condition for the filler from the trained model; and
applying the filler to a gap between an edge portion of the first substrate and an edge portion of the second substrate according to the applying condition, while rotating the laminated substrate.

13. The substrate processing method according to claim 12, wherein the data on the laminated substrate include materials constituting surfaces of the first substrate and the second substrate, and a shape and a size of the gap, and the data on the filler include a composition of the filler.

14. The substrate processing method according to claim 12 or 13, wherein the applying condition includes at least one of a total amount of the filler to be applied, an amount of the filler to be applied per unit time, temperature of the filler, and a rotation speed of the laminated substrate.

15. The substrate processing method according to claim 12 or 13, wherein
data on a curing device configured to cure the filler are input into the trained model in addition to the data on the laminated substrate and the data on the filler,
the applying condition for the filler and a curing condition for the filler are output from the trained model, and
the substrate processing method further comprises curing the applied filler by the curing device according to the curing condition.

16. The substrate processing method according to claim 15, wherein the data on the curing device include a type of the curing device, and a distance between the curing device and an edge portion of the laminated substrate.

17. The substrate processing method according to claim 15, wherein the curing condition includes an output value of the curing device.

18. The substrate processing method according to claim 15, wherein
data on a thinning device configured to thin the laminated substrate are input into the trained model in addition to the data on the laminated substrate, the data on the filler, and the data on the curing device,
the applying condition for the filler, the curing condition for the filler, and a thinning condition for the laminated substrate are output from the trained model, and
the substrate processing method further comprises thinning the laminated substrate by the thinning device according to the thinning condition after curing of the filler.

19. The substrate processing method according to claim 18, wherein the data on the thinning device include a type of a grinding tool for use in the thinning device and a target amount of grinding of the laminated substrate.

20. The substrate processing method according to claim 19, wherein the thinning condition includes at least one of a pressing force of the grinding tool against the laminated substrate, a rotation speed of the grinding tool, and a rotation speed of the laminated substrate.

21. The substrate processing method according to claim 12, wherein the trained model is constructed by the machine learning using training data that include data on laminated substrates, data on fillers, and applying conditions as ground-truth labels.

22. The substrate processing method according to claim 15, wherein the trained model is constructed by the machine learning using training data that include data on laminated substrates, data on fillers, and data on curing devices and further include applying conditions and curing conditions as ground-truth labels.

23. The substrate processing method according to claim 18, wherein the trained model is constructed by the machine learning using training data that include data on laminated substrates, data on fillers, data on curing devices, and data on thinning devices and further include applying conditions, curing conditions, and thinning conditions as ground-truth labels.

24. The substrate processing method according to claim 12, further comprising:
updating training data for use in the machine learning by adding, to the training data, the data on the laminated substrate and the data on the filler which have been input to the trained model, and the applying condition which has been output from the trained model; and
performing machine learning using the updated training data to update the trained model.

25. The substrate processing method according to claim 12, wherein applying the filler to the gap between the edge portion of the first substrate and the edge portion of the second substrate according to the applying condition, while rotating the laminated substrate comprises applying the filler to the gap between the edge portion of the first substrate and the edge portion of the second substrate according to the applying condition, while rotating the laminated substrate held in a vertical posture.

26. A substrate processing method comprising:
inputting, into a trained model, data on a laminated substrate having a first substrate and a second substrate bonded to each other, data on a filler applied to a gap between an edge portion of the first substrate and an edge portion of the second substrate, and data on a thinning device configured to thin the laminated substrate, the trained model being constructed by machine learning;
outputting a thinning condition for the laminated substrate from the trained model; and
thinning the laminated substrate by the thinning device according to the thinning condition.

27. A substrate processing apparatus comprising:
an arithmetic system having a trained model constructed by machine learning; and
a filler application module configured to apply a filler to a laminated substrate having a first substrate and a second substrate bonded to each other, while rotating the laminated substrate,
wherein the arithmetic system is configured to:
input data on the laminated substrate and data on the filler into the trained model;
output an applying condition for the filler from the trained model; and
instruct the filler application module to apply the filler to a gap between an edge portion of the first substrate and an edge portion of the second substrate according to the applying condition.

28. The substrate processing apparatus according to claim 27, wherein the data on the laminated substrate include materials constituting surfaces of the first substrate and the second substrate, and a shape and a size of the gap, and the data on the filler include a composition of the filler.

29. The substrate processing apparatus according to claim 27 or 28, wherein the applying condition includes at least one of a total amount of the filler to be applied, an amount of the filler to be applied per unit time, temperature of the filler, and a rotation speed of the laminated substrate.

30. The substrate processing apparatus according to claim 27 or 28, further comprising a curing device configured to cure the applied filler, the arithmetic system being configured to:
input data on the curing device into the trained model in addition to the data on the laminated substrate and the data on the filler;
output the applying condition for the filler and a curing condition for the filler from the trained model; and
instruct the curing device to cure the applied filler according to the curing condition.

31. The substrate processing apparatus according to claim 30, wherein the data on the curing device include a type of the curing device, and a distance between the curing device and an edge portion of the laminated substrate.

32. The substrate processing apparatus according to claim 30, wherein the curing condition includes an output value of the curing device.

33. The substrate processing apparatus according to claim 30, further comprising a thinning device configured to thin the laminated substrate, the arithmetic system being configured to:
input data on the thinning device into the trained model in addition to the data on the laminated substrate, the data on the filler, and the data on the curing device;
output the applying condition for the filler, the curing condition for the filler, and a thinning condition for the laminated substrate from the trained model; and
instruct the thinning device to thin the laminated substrate according to the thinning condition after curing of the filler.

34. The substrate processing apparatus according to claim 33, wherein the data on the thinning device include a type of a grinding tool for use in the thinning device and a target amount of grinding of the laminated substrate.

35. The substrate processing apparatus according to claim 34, wherein the thinning condition includes at least one of a pressing force of the grinding tool against the laminated substrate, a rotation speed of the grinding tool, and a rotation speed of the laminated substrate.

36. The substrate processing apparatus according to claim 27, wherein the trained model is constructed by the machine learning using training data that include data on laminated substrates, data on fillers, and applying conditions as ground-truth labels.

37. The substrate processing apparatus according to claim 30, wherein the trained model is constructed by the machine learning using training data that include data on laminated substrates, data on fillers, and data on curing devices and further include applying conditions and curing conditions as ground-truth labels.

38. The substrate processing apparatus according to claim 33, wherein the trained model is constructed by the machine learning using training data that include data on laminated substrates, data on fillers, data on curing devices, and data on thinning devices and further include applying conditions, curing conditions, and thinning conditions as ground-truth labels.

39. The substrate processing apparatus according to claim 27, wherein the arithmetic system is configured to:
update training data for use in the machine learning by adding, to the training data, the data on the laminated substrate and the data on the filler which have been input to the trained model, and the applying condition which has been output from the trained model; and
performing machine learning using the updated training data to update the trained model.

40. The substrate processing method according to claim 27, wherein the filler application module includes a substrate holder or a substrate holding device configured to hold the laminated substrate in a vertical posture.

41. A substrate processing apparatus comprising:
an arithmetic system having a trained model constructed by machine learning; and
a thinning device configured to thin a laminated substrate having a first substrate and a second substrate bonded to each other,
wherein the arithmetic system is configured to:
input data on the laminated substrate, data on a filler applied to a gap between an edge portion of the first substrate and an edge portion of the second substrate, and data on the thinning device into the trained model constructed by the machine learning;
output a thinning condition for the laminated substrate from the trained model; and
instruct the thinning device to thin the laminated substrate according to the thinning condition.

42. A computer-readable storage medium storing a program for causing a computer to perform steps of:
inputting data on a laminated substrate and data on a filler into a trained model constructed by machine learning, the laminated substrate having a first substrate and a second substrate bonded to each other;
outputting an applying condition for the filler from the trained model; and
instructing a filler application module to apply the filler to a gap between an edge portion of the first substrate and an edge portion of the second substrate according to the applying condition.
